# EUROPEAN PATENT APPLICATION

(11) **EP 1 835 047 A1**
(43) Date of publication of application: **19.09.2007**
(21) Application number: 05819974.6
(22) Date of filing: 13.12.2005
(51) Int. Cl.: C23C 14/34, H01L 21/285

(54) **OPPOSING TARGET TYPE SPUTTER DEVICE**

(30) Priority: 28.12.2004 JP 2004378805
(71) Applicant: FTS Corporation, Tokyo 192-0024 (JP)
(72) Inventor: ANPUKU, Hisanao, Hachioji-shi, Tokyo 192-0024 (JP); KADOKURA, Sadao, Kokubunji-shi, Tokyo 185-0031 (JP)
(74) Representative: Beetz & Partner
(86) International application number: PCT/JP2005/023218
(87) International publication number: WO 2006/070623

(57) **Abstract**

Provided is a facing-targets sputtering apparatus which attains a target unit of large effective length without employment of an elongated target, and enables a film to be formed on a substrate of large area. The facing-targets sputtering apparatus includes a box-shaped facing-targets sputtering unit 70 and a vacuum chamber 10, the sputtering unit 70 including a rectangular parallelepiped frame 71 having six faces 71a to 71f, one of which (71f) serves as an opening face, and a pair of target units 100a and 100b, each including a target and magnetic-field generation means formed of a permanent magnet which is provided at the periphery of the target, which means generates a facing-mode magnetic field extending in a direction perpendicular to the surface of the target and a magnetron-mode magnetic field extending in a direction parallel to the target surface, in which the target units are provided on opposing faces of the frame which are located adjacent to the opening face, and the remaining three faces 71c to 71e of the frame are shielded with closure plates 72c to 72e (the face 71c and the closure plate 72c, which are on the proximal side, are not illustrated), wherein the sputtering unit is provided on the vacuum chamber such that the opening face faces the vacuum chamber, and a substrate is placed in the vacuum chamber such that the substrate faces the opening face. The target unit 100a includes a plurality of targets 110a₁ and 110a₂, and the target unit 100b includes a plurality of targets 110b₁ and 110b₂ (not illustrated).

## Description

### Technical Field

The present invention relates to a facing-targets sputtering apparatus comprising a facing-targets sputtering unit, the sputtering unit including a pair of targets which are disposed so as to face each other across a predetermined space (hereinafter the space may be referred to as a "confinement space"), and permanent magnets provided at the periphery of each of the facing targets, the permanent magnets generating a facing-mode magnetic field extending in a direction perpendicular to the target surface (hereinafter the direction may be referred to as a "facing direction"), wherein a film is formed on a substrate provided so as to face the confinement space. More particularly, the present invention relates to a suitable improvement in a box-shaped facing-targets sputtering unit comprising facing target units, each including the aforementioned target and the permanent magnets provided at the periphery of the target; and a rectangular parallelepiped frame, wherein the target units are provided on opposing faces of the frame, and, among the remaining four faces of the frame, three faces (excluding the face which serves as an opening face) are closed. Specifically, the present invention relates to an improvement in the facing-targets sputtering apparatus such that the apparatus enables a film to be formed on a substrate of large width by means of an in-line system, and enables a film to be formed on a substrate of large area which is held stationary.

### Background Art

The aforementioned facing-targets sputtering apparatus including the box-shaped facing-targets sputtering assembly, which has been proposed by the present inventor in Japanese Patent Application Laid-Open (kokai) No. 10-330936 (specification of US Patent No. 6,156,172), is constructed as shown in FIG. 18.

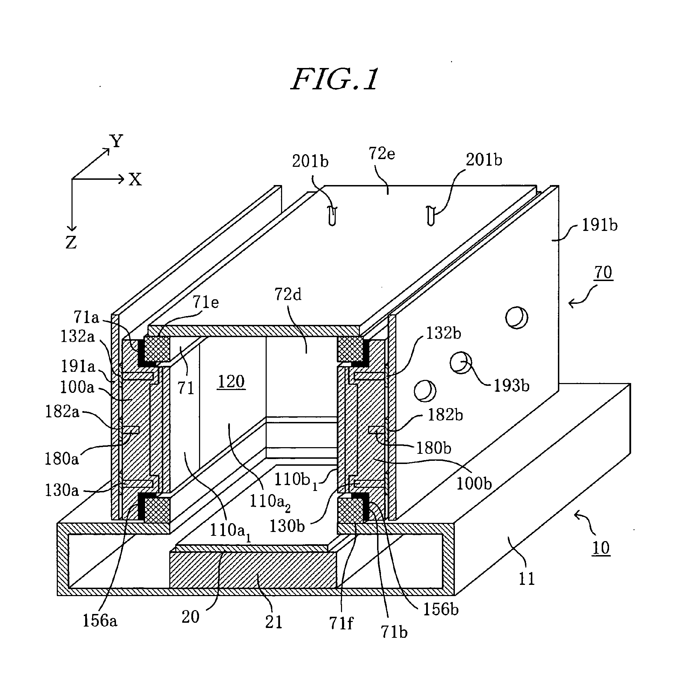

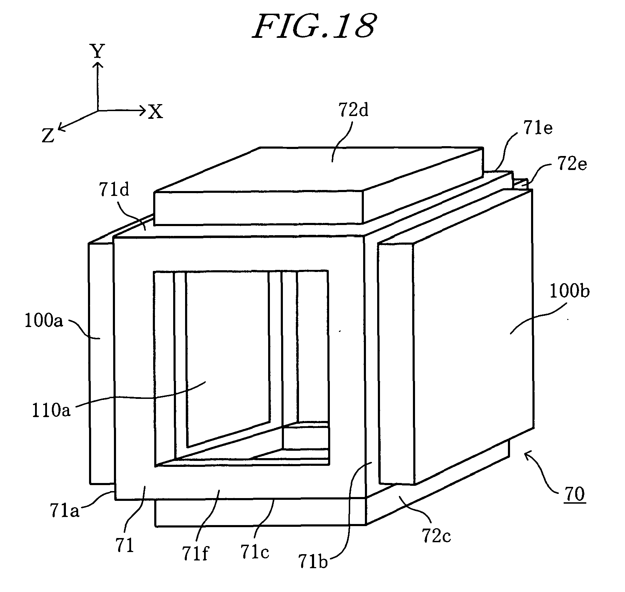

As shown in FIG. 18, a box-shaped facing-targets sputtering assembly 70 is constructed such that target units 100a and 100b are mounted on opposing faces 71a and 71b out of four faces 71a to 71d (among five faces 71a to 71e except an opening face 71f of a rectangular parallelepiped frame 71) which are provided adjacent to an opening face 71f, which serves as an opening of a rectangular parallelepiped frame 71, and such that the three faces 71c to 71e are closed with closure plates 72c to 72e, respectively. The target unit 100a includes a target 110a and magnetic-field generation means formed of a permanent magnet which is provided along the periphery of the target 110a, and the target unit 100b includes a target 110b (not illustrated) and magnetic-field generation means formed of a permanent magnet which is provided along the periphery of the target 110b. The outward form of the sputtering assembly 70 assumes a rectangular parallelepiped box shape, which may be cubic. The box-shaped facing-targets sputtering apparatus has a structure as described below. Specifically, as shown below in FIG. 1, the box-shaped facing-targets sputtering assembly is connected to a vacuum chamber such that the opening face 71f of the sputtering assembly faces the vacuum chamber, and a substrate on which a thin film is to be formed is placed within the vacuum chamber so as to face the opening face 71f.

In this specification, "X direction" refers to a direction of a magnetic field generated so as to surround a confinement space provided between a pair of facing targets (i.e., a facing direction); "Z direction" refers to a direction as viewed from the confinement space toward a substrate on which a film is to be formed; i.e., a direction perpendicular to the surface of the substrate; and "Y direction" refers to a direction orthogonal to X and Z directions; i.e., a direction parallel to the target surface and the substrate surface. Coordinate axes corresponding to X, Y, and Z directions will be referred to as "X-axis," "Y-axis," and "Z-axis," respectively.

In the sputtering apparatus having the above-described structure, a magnetic field for generating and confining sputtering plasma is formed as in the case of a conventional facing-targets sputtering apparatus disclosed in, for example, Japanese Patent Application Laid-Open (kokai) No. 10-8246. Specifically, within a confinement space provided between the facing targets of target units including magnetic-field generation means, a facing-mode magnetic field extending in a direction perpendicular to the targets is formed throughout the targets, and, in addition, a magnetron-mode magnetic field extending in a direction parallel to the surfaces of the targets is formed in the vicinity of the target surfaces at the peripheral edges of the targets. As a result, high-density plasma is generated over the entire surfaces of the targets.

Therefore, in the box-shaped facing-targets sputtering apparatus including the box-shaped facing-targets sputtering assembly, in which the five faces other than the opening face are closed, sputtered particles disperse, via the opening face, in the highly evacuated vacuum chamber in which the substrate is placed, and are deposited onto the substrate, to thereby form a thin film.

The aforementioned conventional box-shaped facing-targets sputtering apparatus has a compact structure, and enables formation of a thin film of high quality at low temperature. Therefore, the sputtering apparatus has been applied to formation of various films. For example, the sputtering apparatus has been applied to formation of electrodes of organic EL devices, which have recently become of interest and have been increasingly developed for commercialization, and various attempts have been made to apply the sputtering apparatus to formation of the electrodes. Attempts have also been made to apply the sputtering apparatus to the field of semiconductor devices. Some applications of the sputtering apparatus are expected to be put into practice before long.

As has been well known, in consideration of mass-production of devices (e.g., display devices and semiconductor devices such as memory devices), a substrate to be employed is required to have a larger area, from the viewpoints of, for example, productivity and cost.

In relation to such requirement, the conventional facing-targets sputtering apparatus has problems as described below. For example, if the distance between the facing targets is increased for a larger substrate, the intensity of a magnetic field in a facing direction for confinement of plasma is lowered, and the facing-targets sputtering assembly does not function. Therefore, essentially, the distance between the facing targets cannot be increased beyond a limit in a facing direction. In the conventional sputtering apparatus, when permanent magnets are employed as magnetic-field generation means, the distance between the magnets is limited to at most about 20 cm. Therefore, when a film is to be formed on a substrate which is held stationary, the size of the substrate is limited to about 20 cm or less. Meanwhile, in the case where the sputtering apparatus employs an in-line system in which film formation is performed while a substrate is moved, the sputtering apparatus can treat a substrate of large area by moving the substrate in an X direction (specifically, in a facing direction) and by increasing the length of the targets in a Y direction (i.e., direction perpendicular to the facing direction). However, in such a case, targets to be employed assume a greatly elongated shape, and become expensive. In addition, there are problems in that, for example, targets are difficult to cool uniformly, leading to a limitation on productivity, and some targets formed of a certain material are prone to break, leading to poor handling.

### Disclosure of the Invention

In order to solve the aforementioned problems, an object of the present invention is to provide a facing-targets sputtering apparatus which can treat a substrate of large area without causing such problems. Specifically, objects of the present invention are to provide a facing-targets sputtering apparatus which can employ an in-line system without causing the aforementioned problems, and a facing-targets sputtering apparatus which can treat a substrate of large area even when the substrate is held stationary.

In order to attain the above-described objects, according to a first embodiment of the present invention, there is provided a facing-targets sputtering apparatus for forming a film on a substrate, comprising:
a) a facing target unit comprising:
   i) a target module including a backing section with cooling means and a rectangular target mounted on the front surface of the backing section;
   ii) a unit support including a module mounting section on a front surface in which the target module is mounted and a magnet accommodation section at the periphery of the module mounting section for accommodating permanent magnets such that the permanent magnets generate a facing-direction magnetic field and;
   iii) permanent magnets being accommodated in the magnet accommodation sections;
   and
b) a facing-targets sputtering assembly including a pair of the facing target units which are disposed such that the targets face each other across a confinement space with a predetermined distance, wherein a film is formed on a substrate which is disposed laterally to the confinement space so as to face the side face of the confinement space,
characterized in that;
the module mounting section of the unit support is divided into a plurality of mounting compartments with a predetermined length in a lateral direction which is parallel to the target surface and the substrate surface, and each of the target module having a predetermined length corresponding to the length of the mounting compartment is hermetically provided on each of the mounting compartments independently and the target modules are mounted on all the mounting compartments, whereby a continuously combined elongated target formed of a plurality of the target modules aligning continuously in the lateral direction covers entirely a film formation region of the substrate extending in the lateral direction.

In order to attain the above-described objects, according to a second embodiment of the present invention, there is provided a facing-targets sputtering apparatus for forming a film on a substrate, comprising:
a facing-targets sputtering assembly including a pair of facing target units which are disposed such that a pair of targets face each other across a confinement space with a predetermined distance and permanent magnets which are disposed at the periphery of each of the targets so as to generate a magnetic field in a facing-direction, wherein a film is formed on a substrate which is disposed laterally to the confinement space so as to face the side face of the confinement space;
   characterized in that;
a combined facing-targets sputtering assembly is formed by combining a plurality of the facing-targets sputtering assemblies by means of an intermediate target unit which includes a plate-like intermediate unit support having, on each of its facing-direction surfaces, one of targets of the facing-targets sputtering assemblies to be combined and permanent magnets provided along the periphery of the intermediate unit support so as to generate a facing-direction magnetic field; and
   the total thickness of the intermediate target unit including the thickness of the targets provided on its both surfaces is equal to or less than a specified thickness value under that the sum of the thickness of respective films on a substrate's portion facing to the side face of the intermediate unit support is above a predetermined thickness, the respective film formed by each of the facing-targets sputtering assemblies provided at the both side of the intermediate target unit, whereby a plurality of film formation regions corresponding to each of the facing-targets sputtering assemblies to be combined are combined in the facing-direction to be a single combined film formation region and thereby the combined facing-targets sputtering assembly with a single film formation region is provided.

In the aforementioned second embodiment of the present invention, preferably, the facing-targets sputtering apparatus is constructed such that wherein each of the target units provided on both terminals of the combined facing-targets sputtering assembly is a terminal target unit comprising:
a) a target module including a backing section with cooling means and a rectangular target mounted on the front surface of the backing section;
b) a unit support including a module mounting section on a front surface which the target module is mounted and a magnet accommodation section at the periphery of the module mounting section for accommodating permanent magnets such that the permanent magnets generate a facing-direction magnetic field and;
c) permanent magnets being accommodated in the magnet accommodation section;
and the intermediate target unit is an intermediate target unit comprising:
a) an intermediate target module including an intermediate unit support having cooling means and targets mounted on both surfaces of the intermediate unit support; and
b) permanent magnets being provided along the peripheral edges of the targets so as to generate a facing-direction magnetic field.

With this structure, the dimension (in a direction perpendicular to the targets) of each of the terminal and intermediate target units; i.e., the thickness of each of the target units, is reduced as a whole, and thereby the degree of overlap of film formation regions corresponding to the facing-targets sputtering assemblies on the respective sides of the intermediate target unit can be increased at a position located laterally to the intermediate target unit, and as well the combined sputtering assembly can be formed to have a compact box-shaped configuration.

The aforementioned predetermined thickness can be determined on the basis of, for example, necessary film thickness distribution. From the viewpoint of uniformity of the film thickness, preferably, the predetermined thickness is equal to or greater than the average thickness of a film formed on a necessary film formation region. In a region located laterally to the intermediate target unit, a film is formed through overlap of sputtered particles being dispersed from each of the sputtering assemblies on both sides of the intermediate target unit. In a film formation region corresponding to each of the sputtering assemblies, the thickness of a film is large at the center of the region and is gradually reduced as the distance from the center increases. Therefore, in order to obtain the average thickness on a film formation region laterally to the intermediate target unit,it is considered sufficient that a film formation region of each of the sputtering assemblies on the both sides of the intermediate target unit is overlapped such that the thickness of a film formed on the film formation region laterally to the intermediate target unit by each of the sputtering assemblies is 50% or more of the maximum thickness of a film formed by each of the sputtering assemblies.

In order to attain the above-described objects, according to a third embodiment of the present invention, there is provided a facing-targets sputtering apparatus, which is a combination of the aforementioned first and second embodiments, wherein, in each of the aforementioned terminal target units, the terminal target unit is a combined target unit in which the module mounting section of the unit support is divided into a plurality of mounting compartments with a predetermined length in the lateral direction which is parallel to the target surface and the substrate surface, and one target module with a predetermined length corresponding to the length of the mounting compartment is hermetically provided on each of the mounting compartments independently, whereby a combined target module formed of a plurality of the target modules aligning in the lateral direction covers entirely a film formation region of the substrate extending in the lateral direction:
and the intermediate target unit is a combined intermediate target unit comprising;
a plurality of intermediate target modules with a predetermined length including an intermediate unit support having cooling means and targets mounted on both surfaces of the intermediate unit support, wherein the intermediate target modules are aligned in a lateral direction and jointed with one another so that the total lateral length of the thus-aligned intermediate target modules is equal to the total lateral length of the terminal target unit; and
the permanent magnets being provided along the peripheral edges of the thus-aligned intermediate target modules so as to generate a facing-direction magnetic field;
and thereby a combined intermediate target module formed of a plurality of the intermediate target modules being aligned in the lateral direction covers entirely a film formation region of the substrate extending in the lateral direction.

In the facing-targets sputtering apparatus according to the first embodiment of the present invention, the target units having the combined target module mentioned below are disposed facing each other. The combined target module comprises a plurality of the target module aligned continuously wherein the length of the unit support in a Y direction (specifically, in a lateral direction) is regulated to be equal to or greater than the length of the substrate in a Y direction; the module mounting section of the unit support is divided into a plurality of mounting compartments, each having an appropriate length; and a target module is mounted in each of the mounting compartments. With this structure, a target of large length is not required, and the effective target length can be increased by means of a combined target module formed of a plurality of aligned target modules, each having a predetermined length. Therefore, according to the facing-targets sputtering apparatus of the first embodiment of the present invention, problems due to employment of an elongated target (e.g., poor workability, cost increase, and non-uniform cooling) can be avoided, and a substrate of large area can be employed. In addition, the target module is standardized in terms of length, and therefore, a target and a backing section of limited standard length can be provided, which leads to great effects in terms of manufacturing cost, maintenance, spare parts, etc.

The facing-targets sputtering apparatus according to the second embodiment of the present invention provides with a combined facing-targets sputtering assembly which is formed to have a single film formation region by combining a plurality of facing-targets sputtering assemblies by means of an intermediate target unit which has, on both surfaces, one of the facing-targets in each of the combining facing-targets sputtering assemblies. According to the facing-targets sputtering apparatus having this structure, a combined facing-targets sputtering assembly which provides a film formation region having unlimited facing-direction effective length can be attained by means of permanent magnets which can only form a facing-targets sputtering assembly with a limited facing-direction distance, and as well a film having uniform thickness can be formed on a substrate of large area which is held stationary, the substrate being elongated in an X direction (specifically, in a facing direction).

The facing-targets sputtering apparatus of the third embodiment of the present invention, which is a combination of the aforementioned first and second embodiments, has no essential limitation on the length in a lateral direction (Y direction) an in a facing direction (X direction), and can form a film on a substrate of large area which is held stationary.

As described above, the present invention can increase the size of a facing-targets sputtering apparatus, which has become of interest in terms of less plasma-induced damage to an underlying layer, but has been difficult to increase in size. The present invention can be widely applied to, for example, production of semiconductor devices, production of flat panel displays (e.g., liquid crystal displays and organic EL displays), and production of functional films (e.g., a film formed of high-performance film (e.g., ITO film) provided on plastic film).

### Brief Description of the Drawings

FIG. 1 is a perspective view showing a sputtering apparatus of a first embodiment of the present invention, with a portion of the apparatus being illustrated by a cross-sectional view.
FIG. 2 is a schematic perspective view of a target unit of the sputtering apparatus of the first embodiment of the present invention.
FIG. 3 is a cross-sectional view of the target unit shown in FIG. 2, as taken along line A-A.
FIG. 4 is a perspective view of auxiliary electrodes employed in the sputtering apparatus of the first embodiment of the present invention.
FIG. 5 is a plan view of a um support employed in the sputtering apparatus of the first embodiment of the present invention.
FIG. 6 is a perspective view showing a sputtering apparatus of a second embodiment of the present invention, with a portion of the apparatus being illustrated by a cross-sectional view.
FIG. 7 is a schematic perspective view of an intermediate target unit employed in the sputtering apparatus of the second embodiment of the present invention.
FIG. 8 is a cross-sectional view of the target unit shown in FIG. 7, as taken along line B-B.
FIG. 9 is a perspective view showing a sputtering apparatus of a third embodiment of the present invention.
FIG. 10 is a schematic perspective view of an intermediate target unit employed in the sputtering apparatus of the third embodiment of the present invention.
FIG. 11 is a cross-sectional view of the target unit shown in FIG. 10, as taken along line C-C.
FIG. 12 is a cross-sectional view of the target unit shown in FIG. 10, as taken along line D-D.
FIG. 13 is a cross-sectional view showing a modification of the embodiments of the present invention.
FIG. 14 is a cross-sectional view showing a modification of the embodiments of the present invention.
FIG. 15 is a cross-sectional view showing a modification of the embodiments of the present invention.
FIG. 16 is a graph showing the film thickness distribution of a film formed in film formation example 1 of the present invention.
FIG. 17 is a graph showing the film thickness distribution of a film formed in film formation example 2 of the present invention.
FIG. 18 is a perspective view of a conventional box-shaped facing-targets sputtering unit.

### Best Mode for Carrying Out the Invention

Embodiments of the present invention will next be described in detail with reference to the drawings.

### [First embodiment]

FIG. 1 is a schematic perspective view showing the box-shaped facing-targets sputtering apparatus according to a first embodiment of the present invention, with a portion of the apparatus being illustrated by a cross-sectional view. In the box-shaped facing-targets sputtering unit (hereinafter may be referred to simply as "box-shaped sputtering unit") 70 of the present embodiment, target units 100a and 100b are hermetically mounted on opposing faces 71a and 71b (on the left and right sides as viewed in FIG. 1) of a rectangular parallelepiped frame 71, respectively, and faces 71c to 71e (the face 71c located on the proximal side and the face 71d located on the distal side are not illustrated), excluding an opening face 71f which is located on the bottom side as viewed in FIG. 1 and which faces a substrate 20, are hermetically covered with closure plates 72c to 72e (the closure plate 72c corresponding to the face 71c located on the proximal side as viewed in FIG. 1 is not illustrated), respectively; i.e., the faces excluding the opening face 71f are hermetically shielded. The box-shaped sputtering unit includes a confinement space 120 therein.

On the opposing surfaces of the target units 100a and 100b, respectively, two targets 100a₁ and 100a₂ and two targets 100b₁ and 100b₂ (the target 100b₂ is not illustrated) are mounted so as to be aligned in a Y direction. The target units 100a and 100b respectively include permanent magnets 130a and 130b for generally generating an X-direction magnetic field, and permanent magnets 180a and 180b for regulating a magnetron-mode magnetic field. The permanent magnets 130a, 130b, 180a, and 180b are fixed in the corresponding accommodation sections by means of fixation plates 132a, 132b, 182a, and 182b, respectively. On the back surfaces of the target units 100a and 100b are respectively provided a pole plate 191a for magnetically connecting the permanent magnets 132a and 182a, and a pole plate 191b for magnetically connecting the permanent magnets 132b and 182b. The pole plates 191a and 191b respectively have openings 193a (not illustrated) and 193b for connecting a cooling-water feed tube and a water drainage tube.

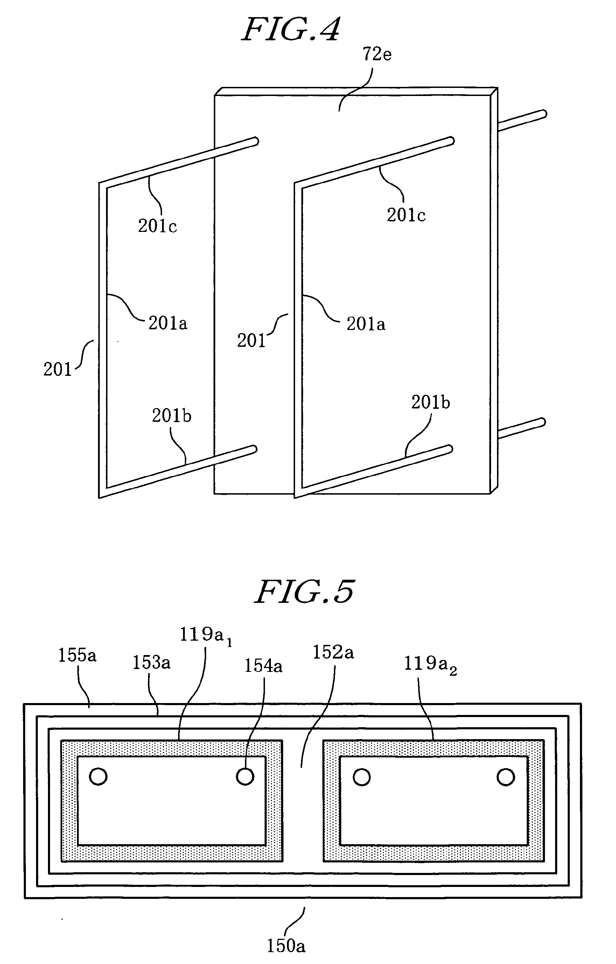

A "U"-shaped auxiliary electrode formed of a copper tube for absorbing electrons, which is shown below in FIG. 4 (the main body of the electrode is not illustrated in FIG. 1 for easy viewing of the sputtering unit), is provided on the front side of each of the target units 100a and 100b (as used herein, "the front side" refers to the side on which the confinement space 120 between the facing targets is provided, and "the back side" refers to the side opposite to the front side). Support sections 201b and 201c (the sections 201c are not illustrated) of the auxiliary electrode are provided on the closure plate 72e.

In the present embodiment, the facing target units 100a and 100b are removably mounted on the frame 71.

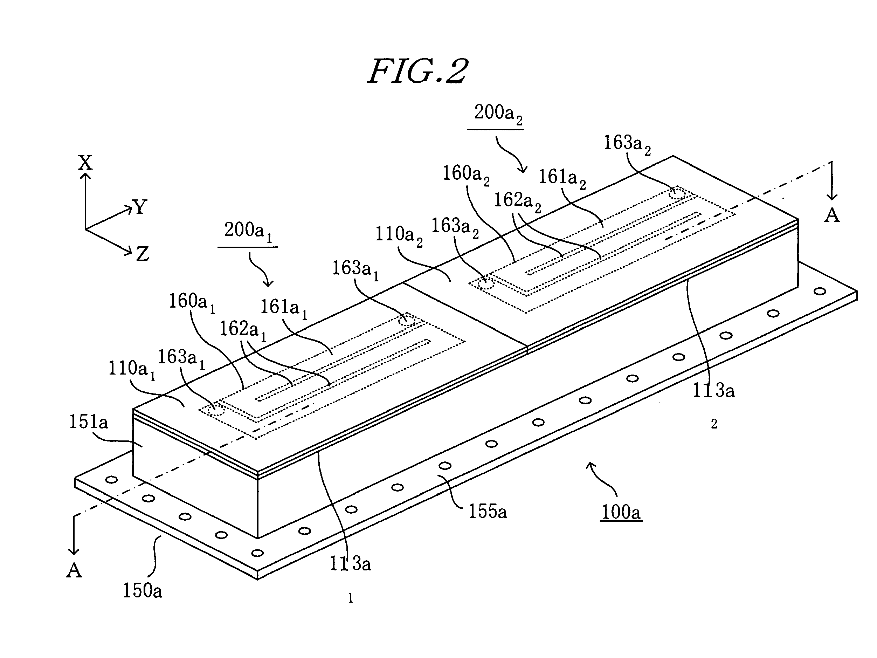

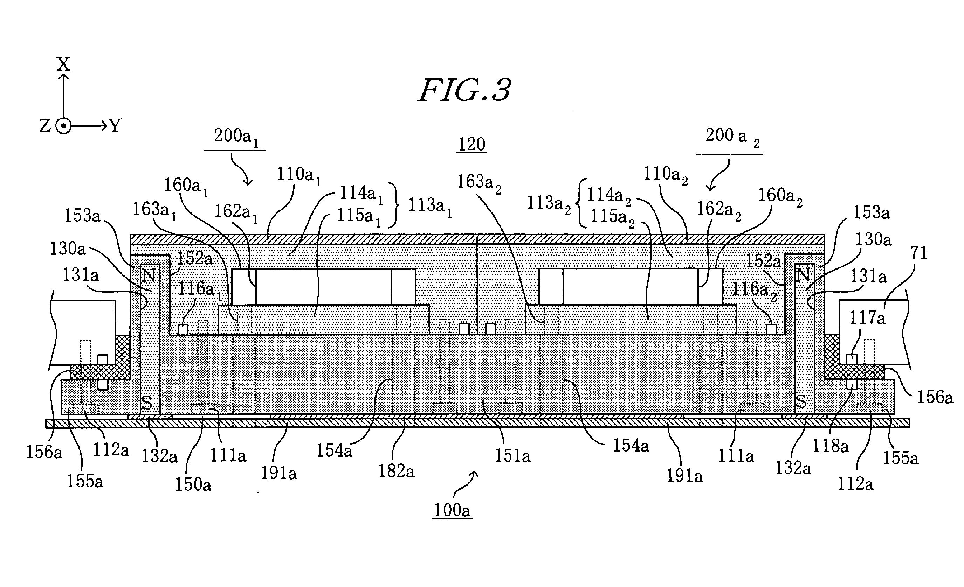

FIG. 2 is a perspective view of the target unit employed in the present embodiment, and FIG. 3 is a cross-sectional view of the target unit shown in FIG. 2, as taken along line A-A. FIGs. 2 and 3 show the configuration of the target unit 100a. The target units 100a and 100b have the same configuration, except that the N and S magnetic poles of the permanent magnet 130a serving as magnetic-field generation means and the permanent magnet 180a serving as magnetic-field regulation means are reversed. Therefore, detailed drawings of the target unit 100b are omitted.

As shown in FIG. 2, the target unit 100a is detachably mounted on the frame 71 by means of a flange 155a of a unit support 150a. In the present embodiment, as described below, the target unit 100a includes a support module and two target modules. On the unit support 150a of the support module, target modules 200a₁ and 200a₂ are mounted so as to be aligned in a Y direction. The target modules 200a₁ and 200a₂ respectively include backing sections 113a₁ and 113a₂, and the targets 110a₁ and 110a₂ which are fixed onto the surfaces of the backing sections 113a₁ and 113a₂. As shown in FIG. 2, the backing sections 113a₁ and 113a₂ have mounting surfaces having the same shape as the targets 110a₁ and 110a₂. In the interior of the backing sections, as shown by a dotted line of FIG. 2, partition walls 162a₁ and 162a₂ which define cooling trenches 161a₁ and 161a₂ are provided, to thereby form cooling jackets 160a₁ and 160a₂. The both ends of the cooling trenches 161a₁ and 161a₂ are respectively connected to connection ports 163a₁ and 163a₂ for supply or drainage of cooling water. The cooling trenches 161a₁ and 161a₂ are formed so as to cover a maximum possible area of the back surfaces of the targets 110a₁ and 110a₂.

As shown in FIG. 3, the backing sections 113a₁ and 113a₂ onto which the targets 110a₁ and 110a₂ are bonded are exchangeably mounted by means of bolts 111a arranged at certain intervals, and hermetically mounted by means of O rings 116a₁ and 116a₂, on a concave section 152a serving as a module mounting section for mounting the target module provided on the front surface of the unit support 150a constituting the support module.

The cooling jackets 160a₁ and 160a₂ are formed as follows: step-down concave sections having partition walls 162a₁ and 162a₂ are formed on the back side of thick, plate-like backing main bodies 114a₁ and 114a₂, which constitute the backing sections 113a₁ and 113a₂; and backing lids 115a₁ and 115a₂ having connection ports 163a₁ and 163a₂ are welded to the step-down concave sections, to thereby hermetically seal the concave sections. The backing sections 113a₁ and 113a₂ and the partition walls 162a₁ and 162a₂ are formed of a highly thermally conductive material (specifically, copper in the present embodiment). Although not illustrated, tubes formed of synthetic resin are provided by way of through holes 154a formed in the unit support 150a, and connected to the connection ports 163a₁ and 163a₂ by means of a connection tool such that cooling water can flow through the cooling jackets 160a₁ and 160a₂.

The targets 110a₁ and 110a₂ are bonded to the front surfaces of the backing sections 113a₁ and 113a₂ by means of a highly thermally conductive adhesive material (e.g., indium), to thereby form the target modules 200a₁ and 200a₂. The target modules 200a₁ and 200a₂ are mounted on the concave section 152a serving as a module mounting section of the support module described below in detail by means of the bolts 111a, such that the cooling jackets 160a₁ and 160a₂ are shielded from a vacuum space (confinement space 120) by means of the O rings 116a₁ and 116a₂ for vacuum sealing, and such that the concave section 152a comes into direct contact with the back surfaces of the backing sections 113a₁ and 113a₂.

With the above-described configuration, in which the targets 110a₁ and 110a₂ of the two target modules 200a₁ and 200a₂ are aligned in a Y direction, a combined target which has a large effective length in a Y direction can be employed, and thus a film can be formed on a substrate which is long in this direction. Therefore, by means of an in-line system in which film formation is performed while a substrate is conveyed in an X direction, film formation can be performed on a continuous film which is long in a Y direction (specifically, a continuous film having a large lateral length), a wafer sheet of large area having a large lateral length, or a substrate (e.g., a glass substrate) having a large lateral length. The target modules 200a₁ and 200a₂ respectively have the cooling jackets 160a₁ and 160a₂, which are independent from each other, and thus the targets 110a₁ and 110a₂ are independently cooled, whereby uniform and effective cooling can be attained. Therefore, large electric power can be applied, and thus productivity can be improved. In the case where, for example, small electric power is applied; i.e., film formation rate is low and less cooling is required, depending on the situation, the two cooling jackets 160a₁ and 160a₂ of the target modules 200a₁ and 200a₂, to which cooling water can be supplied independently, may be connected in series by means of piping such that water drained from one of the cooling jackets is supplied to the other, to thereby simplify the piping system.

In the present embodiment, the effective length of the target in a Y direction is increased. If necessary, by means of the below-described permanent magnet 180a serving as magnetic-field regulation means, erosion of the combined target in a Y direction can be controlled, and the film thickness distribution in this direction can be regulated.

The support module includes the unit support 150a, which is formed from a highly thermally conductive material (in the present embodiment, an aluminum block) through machining so as to have a shape shown in FIG. 2. The flange 155a constituting the unit support 150a is hermetically mounted on the frame 71 in an electrically insulated manner by means of bolts 112a which have electrically insulating sleeves and are arranged at certain intervals, via a packing 156a and O rings 117a and 118a for vacuum sealing, which are formed of an electrically insulating material (in the present embodiment, a heat-resistant resin).

As shown in FIG. 2, the unit support 150a includes the support main body 151a having a rectangular parallelepiped shape, and the flange 155a provided on the surface (on the bottom side as viewed in FIG. 2) of the main body 151a. The flange 155a, which is to be provided on the frame 71, has a predetermined width. The concave section 152a serving as a module mounting section on which the target module is to be mounted is formed on the front surface (top surface as viewed in FIG. 2) of the support main body 151a. As shown in FIG. 3, the accommodation section 131a for accommodating the permanent magnet 130a serving as magnetic-field generation means is provided, from the bottom side (as viewed in FIG. 3); i.e., the side opened to air (hereinafter may be referred to as the "open-air side"), in the peripheral wall 153a surrounding the concave section 152a.

The concave section 152a serving as a module mounting section is configured as shown in FIG. 5 so as to mount the two target modules. Specifically, the bottom surface of the concave section 152a serving as a module mounting section is divided into two compartments in a Y direction. In the thus-formed compartments, sealing surfaces 119a₁ and 119a₂ for the O rings 116a₁ and 116a₂ which are set on the back surfaces of the backing sections 113a₁ and 113a₂ are formed, such that the target modules can be independently mounted with sealing. Therefore, when a plurality of target modules are mounted in the mounting compartments, a combined target module can be formed of the target modules which are aligned in a Y direction. In FIG. 5, bolt holes for attachment of the target modules are not illustrated for drawing simplification. In the present embodiment, the lateral end surfaces on the front side (top side as viewed in FIG. 3) of the peripheral wall 153a are covered with overhanging portions of the backing sections 113a₁ and 113a₂ of the target modules and with end portions of the targets 110a₁ and 110a₂. With this configuration, the overhanging portions and the target end portions provided thereon act as conventional electron reflection means. However, unlike the case of conventional electron reflection means mounted on the backing sections via the below-described support members, the target end portions are bonded directly to the overhanging portions of the backing sections 113a, and 113a₂. Therefore, very effective cooling is attained, and a large amount of electric power can be applied, whereby productivity can be improved as a whole. In addition, the configuration in the vicinity of the targets is much simplified, which is very advantageous in terms of cost. However, in the case of the configuration wherein the target end portions act as electron reflection means, when the targets are formed of a magnetic material, difficulty is encountered in generating a magnetron-mode magnetic field. In the case where a magnetron-mode magnetic field must be reliably generated in the vicinity of the front surfaces of the peripheral edges of the targets 110a₁ and 110a₂ (including the case where the targets are formed of a magnetic material), preferably, the overhanging portions of the backing sections 113a₁ and 113a₂ and the end portions of the targets 110a₁ and 110a₂, which are overlapped with the peripheral wall 153a, are removed, and, similar to the case of conventional electron reflection means having an electron reflection plate, the height of the peripheral wall 153a is increased; i.e., the level of the magnetic pole end of the permanent magnet 130a is increased such that the magnetic pole end surface (on the front side) of the permanent magnet 130a projects into the interior of the vacuum chamber by a predetermined length as measured from the front surfaces of the targets 110a, and 110a₂.

At a center portion on the back side of the support main body 151a of the unit support 150a, a trench having a predetermined depth is provided in parallel with the Y-axis so as to cover almost the full length of the targets 110a₁ and 110a₂. This trench is provided for mounting therein the permanent magnet 180a (see FIG. 1) serving as magnetic-field regulation means. The permanent magnet (180a) may be provided in the trench so as to fill the entirety of the trench, or permanent magnets 180a may be provided so as to be arranged at certain intervals. The permanent magnet (180a) serving as magnetic-field regulation means is magnetically connected to the permanent magnet 130a serving as magnetic-field generation means by means of the pole plate 191a via the fixation plates (182a) and 132a. The pole plate 191a, which is formed of a ferromagnetic material, is magnetically connected to the pole plate (191b) of the target unit (100b) by means of a connection plate formed of a ferromagnetic material which covers the entire surface of a non-illustrated closure plate (e.g., closure plate 72c, 72d, or 72e). The connection plate for magnetically connecting the pole plates 191a and 191b may be a plate-like body which is inserted between the chamber wall 11 of the vacuum chamber 10 and the frame 71, and which has an opening so as not to narrow the opening face of the frame 71. The pole plate 191a can be mounted on the target unit 100a in a sufficiently strong manner by means of merely magnetic forces of the permanent magnets 130a and 180a. However, from the viewpoint of safety, the pole plate 191a may be fixed to the target unit 100a by means of, for example, screws having electrically insulating sleeves. The pole plate 191a is electrically insulated from the target unit 100a by means of the fixation plates (182a) and 132a formed of an electrically insulating material, and is maintained at, for example, ground potential.

As shown in FIG. 3, the accommodation section 131a has an outwardly opened hole of predetermined depth such that the permanent magnet 130a serving as magnetic-field generation means is removably placed therein from the outside of the vacuum chamber (i.e., from the open-air side). The permanent magnet 130a is provided into the hole of the accommodation section 131a such that the magnetic poles of the magnet 130a are arranged as shown in FIG. 3. In the present embodiment, the permanent magnet 130a is formed of a commercially available plate-like permanent magnet (e.g., AlNiCo magnet) of predetermined length and width, and a predetermined number of the permanent magnets 130a are provided along the peripheral edges of a combined target formed of the target 110a₁ and 110a₂ (i.e., virtual target formed of the target 110a₁ and 110a₂). In the present embodiment, the permanent magnet 130a is fixed to the accommodation section by means of an electrically insulating material (specifically, the fixation plate 132a formed of a thin resin plate).

As shown above in FIG. 1, with the above-described configuration, the permanent magnet 130a and the permanent magnet 130b provided in the target unit 100b, which faces the target unit 100a, generate a magnetic field for confinement of plasma; i.e., a facing-mode magnetic field extending in an X direction in such a manner as to surround a confinement space (i.e., space provided between a pair of facing combined targets) 120. Meanwhile, the permanent magnet 130a alone, or combination of the permanent magnet 130a, the permanent magnet 180a, and the pole plate 191a generates an arcuate magnetron-mode magnetic field along the periphery of a combined target formed of the targets 110a₁ and 110a₂, which magnetic field extends from the surface of an end portion of the combined target (110a₁ + 110a₂) that is located above the permanent magnet 130a toward the surface in the vicinity of a center portion of the combined target. The facing-mode magnetic field dominates sputtering of the center portion of the combined target, whereas the magnetron-mode magnetic field dominates sputtering of the peripheral portion of the combined target. As a result, the entire surface of the target (excluding the aforementioned peripheral edge portion which acts as electron reflection means) is almost uniformly sputtered.

As describe above, in the present embodiment, the permanent magnet 180a serving as magnetic-field regulation means is provided for generally increasing the intensity of the magnetron-mode magnetic field. The permanent magnet 180a is fixed by means of the fixation plate 182a which is formed of a thin resin plate as in the case of the fixation plate 132a. Through the magnetic-field regulation means, the magnetron-mode magnetic field extending in the vicinity of the front surface of the peripheral edge of the combined target formed of the targets 110a₁ and 110a₂ can be regulated. Therefore, confinement of plasma at the peripheral edge of the target, which is dominated by the magnetron-mode magnetic field, can be regulated separately from plasma confinement dominated by the facing-mode magnetic field, whereby the target can be uniformly eroded, and a thin film can be formed so as to attain a uniform thickness in a Y direction.

In the box-shaped sputtering unit, confinement of electrons is enhanced within the confinement space of the sputtering unit, as compared with the case of a side-opened-type sputtering apparatus, and in some cases, depending on the type of a target material, etc., a problem arises in that thermoelectrons which have lost energy leak from the opening of the box-shaped sputtering unit. In order to cope with such a problem, in the present embodiment, an auxiliary electrode for absorbing electrons directly from the plasma confinement space (merely the support section 201b of the electrode is shown in FIG. 1) is provided such that the support sections of the electrode are hermetically welded to through holes of the closure plate 72e, and the main body of the electrode is located in the confinement space. FIG. 4 is a perspective view of the closure plate 72e on which the auxiliary electrode is mounted. In the present embodiment, the auxiliary electrode includes a main body 201a and the support sections 201b and 201c, which are formed of a copper tube so as to correspond to the aforementioned combined target end portion serving as electron reflection means at which thermoelectrons tend to remain. The auxiliary electrode is formed of a "U"-shaped tubular electrode 201, and a portion of the support sections thereof projects from the closure plate 72e to the outside (i.e., the portion is exposed to air). The main body 201a, which is not illustrated in FIG. 1 for easy viewing of the sputtering unit, is provided in the confinement space 120 so as to be arranged in parallel with the lower end portions (see FIG. 1) of the targets 110a₁, 110a₂, 110b₁, and 110b₂. The support sections 201b and 201c are provided along the proximal and distal end portions (see FIG. 1) of the targets and in the vicinity of the front surfaces of the targets, such that the support sections are arranged in parallel with the target surfaces. Anode potential (ground potential) is applied to the tubular electrode 201 as in the case of the closure plate 72e, and the electrode absorbs excess electrons (including thermoelectrons) generated in the confinement space. Cooling water is circulated through the tubular electrode 201 for forced cooling of the electrode.

The arrangement and shape of the auxiliary electrode are not limited to those shown in FIG. 4. No particular limitation is imposed on the arrangement and shape of the auxiliary electrode, so long as the electrode is provided in the vicinity of a position at which thermoelectrons tend to remain. When such an auxiliary electrode was provided, emission of light, which occurs when electrons remain in the plasma confinement space, was found to be considerably reduced, and an increase in the temperature of the substrate during the course of film formation was found to be suppressed.

As describe above, the target unit 100a is configured such that the two target modules 200a₁ and 200a₂ are aligned on the unit support 150a. The flange 155a of the target unit 100a is mounted on the frame 71, via the packing 156a and the O rings 117a and 118a for vacuum sealing, which are formed of an electrically insulating material (specifically, a heat-resistant resin), by means of sleeves (not illustrated) formed of an electrically insulating material and the bolts 112a arranged at certain intervals. Thus, as shown in FIG. 1, the target unit 100a is hermetically mounted on the frame 71 in an electrically insulated manner, whereby the below-described box-shaped sputtering unit 70 is constructed.

The box-shaped sputtering unit 70 includes the frame 71 formed of a rectangular parallelepiped structural material (aluminum in the present embodiment). The above-described target units 100a and 100b are hermetically mounted on the faces 71a and 71b of the frame 71, respectively, such that the target units are electrically insulated from the frame 71. Closure plates 72c to 72e are hermetically mounted on the faces 71c to 71e (excluding the opening face 71f which faces the substrate 20) by means of bolts (not illustrated) via O rings (not illustrated) (the faces 71c and 71d and the closure plate 72c are not illustrated), to thereby form a closed structure. No particular limitation is imposed on the material of the closure plates 72c to 72e, so long as the plates exhibit thermal resistance, and vacuum sealing is attained by the plates. Therefore, the closure plates 72c to 72e may be formed of a generally employed structural material. In the present embodiment, the closure plates 72c to 72e are formed of lightweight aluminum, which is employed for forming the frame 71. If necessary, a cooling tube or the like is provided outside each of the closure plates 72c to 72e for cooling the closure plate.

The box-shaped sputtering unit 70 is hermetically mounted on the chamber wall 11 of the vacuum chamber 10 by means of bolts such that the opening of the unit 70 (i.e., the opening face 71f of the frame 71 on the bottom side as viewed in FIG. 1) faces the vacuum chamber 10. Therefore, the vacuum chamber 10 is electrically connected to the frame 71 by means of attachment bolts. In the present embodiment, the facing-targets sputtering apparatus is constructed such that film formation is performed while the substrate 20 is held stationary on a substrate holder 21. However, the sputtering apparatus may employ an in-line system wherein film formation is performed while the substrate is moved in a facing direction through conveying means. The sputtering apparatus is constructed such that a known load lock chamber (not illustrated) is connected to one of the side surfaces of the vacuum chamber 10, and the substrate 20 is supplied to or removed from the substrate holder 21 through non-illustrated substrate carrying-in/carrying-out means.

In the box-shaped sputtering unit 70 having the above-described configuration, the facing targets 110a₁ and 110b₁ or the facing targets 110a₂ and 110b₂ (the target 110b₂ is not illustrated), which constitute the corresponding combined target, are disposed a predetermined distance away from each other, and a magnetic field for confining plasma is generated as in the case of the conventional sputtering apparatus shown above in FIG. 18. Therefore, when a sputtering power supply is connected to an appropriate position of the chamber wall 11 of the vacuum chamber 10 serving as an anode and to appropriate positions of the target units 100a and 100b serving as a cathode, and sputtering power is supplied while sputtering gas (e.g., Ar) is brought into the sputtering unit, sputtering of the targets is performed as in the case of the conventional sputtering apparatus. As described below in film formation examples, in the facing-targets sputtering apparatus, film formation can be performed in a wide region as expected, and the film formation region is basically not limited by the lateral length of the substrate.

### [Second embodiment]

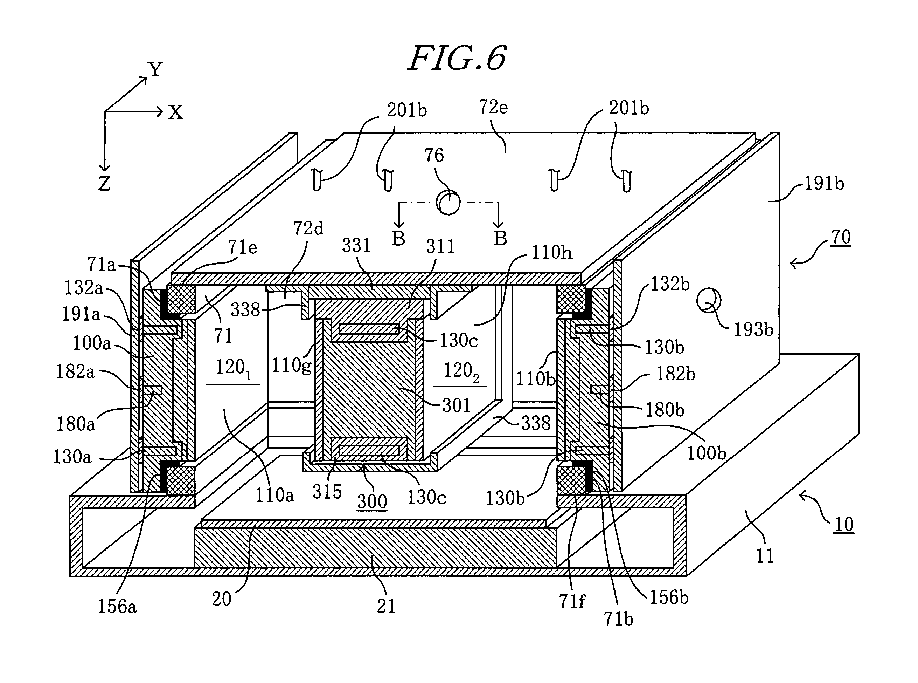

FIG. 6 is a schematic perspective view showing the box-shaped facing-targets sputtering apparatus according to a second embodiment of the present invention, with a portion of the apparatus being illustrated by a cross-sectional view. In the box-shaped sputtering unit 70 of the present embodiment, target units 100a and 100b, which are located at both terminals of the sputtering unit, are hermetically mounted on opposing faces 71a and 71b (on the left and right sides as viewed in FIG. 6) of a rectangular parallelepiped frame 71, respectively, and faces 71c to 71e (a face 71c located on the proximal side and a face 71d located on the distal side are not illustrated), excluding an opening face 71f which is located on the bottom side as viewed in FIG. 6 and which faces a substrate 20, are hermetically covered with closure plates 72c to 72e (the closure plate 72c corresponding to the face 71c located on the proximal side as viewed in FIG. 6 is not illustrated), respectively; i.e., the faces excluding the opening face 71f are hermetically shielded. In addition, an intermediate target unit 300 is provided via an insulating plate 331 on the closure plate 72e at a position between the target units 100a and 100b. The intermediate target unit 300 has, on both of its surfaces, targets 110g and 110h which respectively face the target units 100a and 100b to form facing-targets sputtering units. The sputtering apparatus of the present embodiment is constructed such that facing-targets sputtering units including two confinement spaces 120₁ and 120₂ provided between the target units 100a and 100b are combined into a facing-targets sputtering unit providing one film formation region.

The target units 100a and 100b located at both terminals (in a facing direction) of the combined facing-targets sputtering unit basically have the same configurations as those shown above in FIG. 1, except that each of the target units 100a and 100b has a target module different from the combined target module shown in FIG. 1, and is formed of a single target module as in the case of the conventional sputtering apparatus. Reference numerals of members constituting the target units of FIG. 6 are the same as shown in FIG. 1. Therefore, detailed description of the target units is omitted, and merely essential points will next be described. Specifically, rectangular targets 110a and 110b, which have the same size, are mounted on the opposing surfaces of the target units 100a and 100b, respectively. The target units 100a and 100b respectively include permanent magnets 130a and 130b for generally generating an X-direction magnetic field, and permanent magnets 180a and 180b for regulating a magnetron-mode magnetic field. The permanent magnets 130a, 130b, 180a, and 180b are fixed in the corresponding accommodation sections by means of fixation plates 132a, 132b, 182a, and 182b, respectively. On the back surfaces of the target units 100a and 100b are respectively provided a pole plate 191a for magnetically connecting the permanent magnets 130a and 180a, and a pole plate 191b for magnetically connecting the permanent magnets 130b and 180b. The pole plates 191a and 191b respectively have openings 193a (not illustrated) and 193b for connecting a cooling-water feed tube and a water drainage tube.

The intermediate target unit 300 includes an intermediate target module; magnet holding means (a magnet holding tool 311 and magnet holding casings 314 to 316 (the casings 314 and 316 are not illustrated)) for holding permanent magnets 130c which generate a magnetic field in an X direction (specifically, in a facing direction); and the permanent magnets 130c held in the holding means. The intermediate target module includes an intermediate unit support 301 which is formed of a thick plate-like body having the same shape as the targets (i.e., rectangular shape), which has, on both sides, parallel surfaces on which the targets are mounted, and which has a cooling jacket in the interior thereof (the jacket is not illustrated in FIG. 6 for easy viewing of the sputtering apparatus); and the targets 110g and 110h which are mounted on the surfaces of the unit support 301 that face the confinement spaces 120₁ and 120₂. The magnet holding means are mounted on four surfaces of the intermediate unit support 301 other than the surfaces on which the targets are mounted. As shown in FIG. 6, the exposed surfaces (other than the surfaces on which the targets 110g and 110h are mounted) of the intermediate target unit 300 are covered with shield plates 338 for preventing the exposed surfaces from being sputtered. The shield plates 338 are mounted directly on the closure plate 72e. The closure plate 72e, on which the intermediate target unit 300 is mounted, has a through hole 76 for connecting a tube for circulating cooling water through the cooling jacket provided in the intermediate unit support 301. Similar to the case of the first embodiment, in the present embodiment, auxiliary electrodes for absorbing electrons are provided in the vicinity of the front end portions of the targets 100a, 100g, 100h, and 100b (the interior of the confinement spaces is not illustrated for drawing simplification), and support sections 201b and 201c (the sections 201c are not illustrated) of the auxiliary electrodes penetrate the closure plate 72e and extend to the outside.

Similar to the case of the conventional sputtering apparatus, the facing targets 110a and 110g are disposed a predetermined distance away from each other, to thereby provide the confinement space 120₁, and the permanent magnets 130a and 130c are respectively provided on the back surfaces of the end portions of the targets 110a and 110g so as to be arranged along the peripheries of the targets. Similarly, the facing targets 110b and 110h are disposed a predetermined distance away from each other, to thereby provide the confinement space 120₂, and the permanent magnets 130b and 130c are respectively provided on the back surfaces of the end portions of the targets 110b and 110h so as to be arranged along the peripheries of the targets. In this case, the permanent magnets 130c are common in the targets 100g and 100h, and the permanent magnets 130a and 130c (or the permanent magnets 130b and 130c) are arranged such that the facing magnetic poles differ from each other. Therefore, in each of the facing-targets sputtering units including the confinement spaces 120₁ and 120₂ provided on both sides of the intermediate target unit 300, a predetermined facing-mode magnetic field is generated, and plasma is confined in each of the confinement spaces. At the same time, an arcuate magnetron-mode magnetic field is generated in the vicinity of the surface of the peripheral edge of each of the targets, since the permanent magnets are arranged along the peripheries of the target modules. In the present embodiment, permanent magnets 180a and 180b serving as magnetic-field regulation means for regulating the magnetron-mode magnetic field are provided in the target units 100a and 100b for facilitating, for example, matching with the intermediate target unit 300. However, the permanent magnets 180a and 180b may be omitted if magnetic-field regulation is not required.

A vacuum chamber 10 is provided below the combined facing-targets sputtering unit formed of the two facing-targets sputtering units including the confinement spaces 120₁ and 120₂. A chamber wall 11 of the vacuum chamber 10 has an opening at a portion facing the bottom surface (as viewed in FIG. 6) of the combined facing-targets sputtering unit. In the vacuum chamber 10, a substrate holder 21 for holding the substrate 20 is provided below the opening. Similar to the case of the aforementioned first embodiment, a load lock chamber (not illustrated) is connected to one of the proximal and distal sides (as viewed in FIG. 6) of the vacuum chamber 10, so that the substrate 20 can be supplied to or removed from the chamber.

As described above, the terminal target units 100a and 100b are mounted on the faces 71a and 71b of the frame 71 via the packings 156a and 156b formed of a heat-resistant resin, and the closure plates 72c to 72e are mounted on the faces 71c to 71e of the frame 71 (the faces 71c and 71d and the closure plate 72c are not illustrated). As described below, the intermediate target unit 300 is hermetically mounted, via an insulating plate 331 formed of a heat-resistant resin or a similar material, on the surface of the closure plate 72e that faces the vacuum chamber, whereby the box-shaped sputtering unit 70 is configured. The box-shaped sputtering unit 70 is mounted on the vacuum chamber 10 by mounting the frame 71 on the chamber wall 11 of the vacuum chamber 10 by means of bolts. The target units 100a and 100b, the closure plates 72c to 71e, and the vacuum chamber 10 are hermetically mounted on the frame 71 via O rings, and the confinement spaces 120₁ and 120₂ and the interior of the vacuum chamber 10 are shielded from air.

Sputtered particles generated through sputtering of the facing target surfaces approach and are deposited on the film formation region of the substrate 20 which faces and is located directly below (as viewed in FIG. 6) the facing-targets sputtering units including the confinement spaces 120₁ and 120₂, whereby a film is formed on the substrate. In this case, sputtered particles also approach the region below (as viewed in FIG. 6) the intermediate target unit 300, and, in this region, a film having a thickness smaller than that of the film formed on the region directly below the confinement spaces is formed. That is, film formation by means of the facing-targets sputtering unit is performed not only on the region facing the opening of the sputtering unit, but on its surrounding region. In the region corresponding to the center of the opening of the sputtering unit, sputtered particles are deposited at almost the same rate, and a film having almost uniform thickness is formed. However, as the distance from the center of the opening increases, the deposition rate is gradually lowered, and the thickness of a film to be formed is reduced. Thus, in the region directly below the intermediate target unit 300, a film is formed through overlap and combination of sputtered particles generated in the facing-targets sputtering units provided on both sides of the unit 300. Therefore, conceivably, when sputtering conditions are appropriately selected, and the thickness of the intermediate target unit 300 in an X direction (specifically, the distance between the surfaces of the targets 110g and 110h) is appropriately determined, the thickness of a film to be formed on the region directly below the facing-targets sputtering units including the confinement spaces 120₁ and 120₂ can be adjusted to be almost equal to that of a film to be formed on the region directly below the intermediate target unit 300; i.e., a film having almost uniform thickness can be formed on the substrate 20 with reduced film thickness variation in an X direction. That is, according to the present embodiment, by means of the combined facing-targets sputtering unit formed of the facing-targets sputtering units provided on both sides of the intermediate target unit, the region on which a film having uniform thickness is formed can be effectively extended in an X direction (specifically, in a facing direction), and a film can be formed under stationary conditions on a substrate of large area whose size in an X direction is not limited.

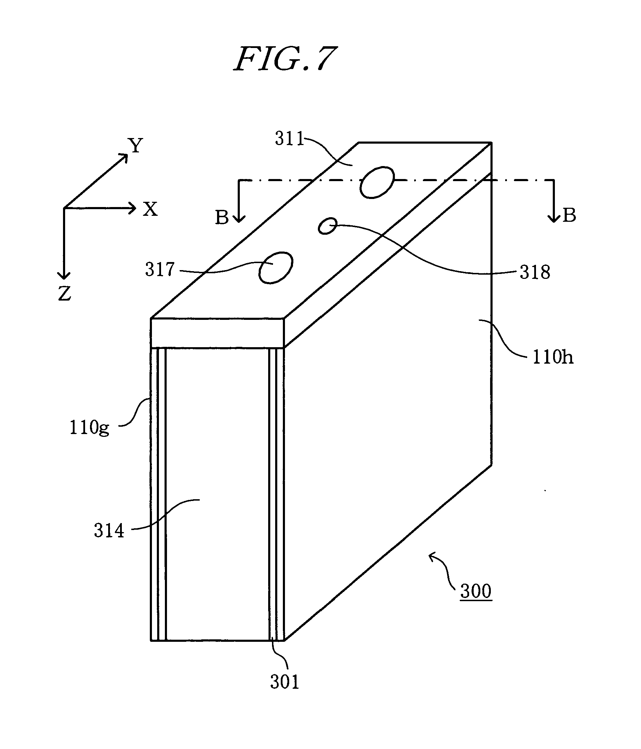

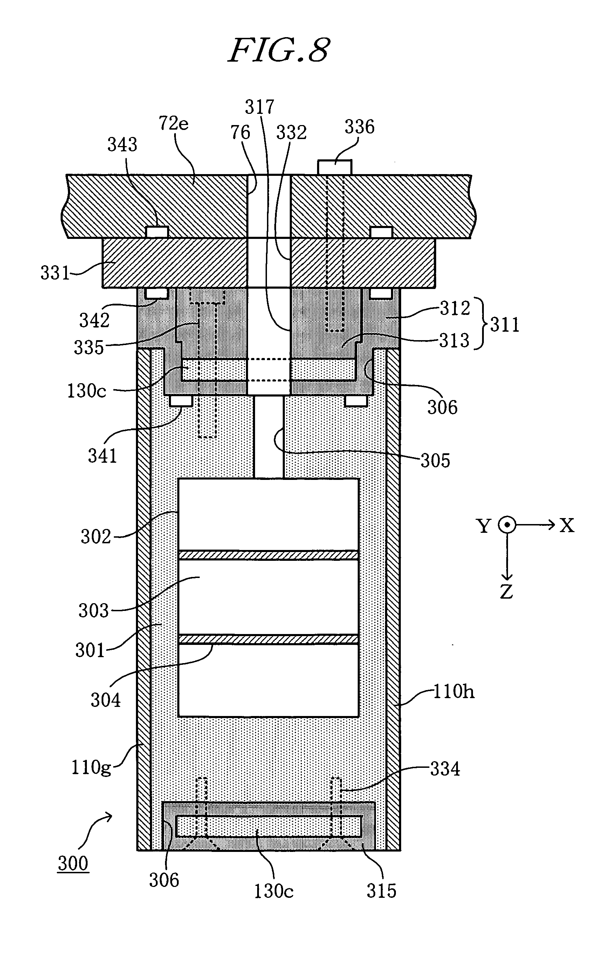

FIG. 7 is a perspective view of the intermediate target unit 300, and FIG. 8 is a cross-sectional view of the target unit shown in FIG. 7, as taken along line B-B. FIG. 8 also shows the closure plate 72e and the insulating plate 331, so as to illustrate the state where the intermediate target unit 300 is mounted on the closure plate 72e. As shown in FIG. 8, the intermediate unit support 301 is formed of a highly thermally conductive, thick copper plate-like body having, on its opposite sides, target mounting surfaces. The intermediate unit support 301 includes, in its interior, a cooling jacket 302 formed of a cooling trench 303 comparted by partition walls 304. Connection ports 305 are formed at both ends of the cooling trench 303, and cooling water is supplied or drained through tubes connected to the connection ports. As shown in FIGs. 7 and 8, the targets 110g and 110h are bonded to the target mounting surfaces of the intermediate unit support 301 by means of, for example, indium. Magnet accommodation trenches 306 are provided on the remaining four surfaces of the intermediate unit support 301. In the magnet accommodation trenches 306 of the three surfaces (excluding the surface on the open-air side; i.e., the top surface as viewed in FIGs. 7 and 8) of the remaining four surfaces, the magnet holding casings 314 to 316 (the casing 316 is not illustrated) serving as magnet holding means accommodating the permanent magnets 130c are mounted by means of screws 334.

On the open-air-side surface of the intermediate unit support 301 is mounted a magnet holding tool 311 which serves as magnet holding means for accommodating the permanent magnet 130c and serves as a section for hermetically connecting the unit support to the closure plate 72e provided outside the target unit. The magnet holding tool 311 includes a main body 312 having a step-down concave section for holding the permanent magnet 130c in an X direction (specifically, in a facing direction); and a lid 313 which is mated in the step-down concave section. The back surface of the step-down concave section and the front end surface of the side portion of the concave section are sealable, and the main body 312 and the lid 313 of the magnet holding tool 311 are hermetically mounted on the intermediate unit support 301 by means of bolts 335 with the permanent magnet 130c being held in the holding tool 311 in an x direction. The intermediate target unit 300 is supported by the closure plate 72e and electrically insulated therefrom by mounting the magnet holding tool 311, via the insulating plate 331, on the closure plate 72e by means of bolts 336 having insulating sleeves. The magnet holding tool 311 and the insulating plate 331 respectively have through holes 317 and 332 for connecting cooling water supply tubes. The insulating plate 331 has a through hole (not illustrated) for connecting a sputtering power supply wire to a wire connection section 318 provided in the lid 313 of the magnet holding tool 311. These through holes and the cooling jacket 302 of the intermediate unit support 301 are shielded from the vacuum space by means of O rings 341 to 343. The magnet holding tool 311 and the magnet holding casings 314 to 316 (the casing 316 is not illustrated) are formed of a lightweight aluminum alloy.

The permanent magnets 130c accommodated in the magnet holding tool 311 and the magnet holding casings 314 to 316 are drilled such that the screws 334, the bolts 335, or cooling water supply tubes can pass therethrough.

### [Third embodiment]

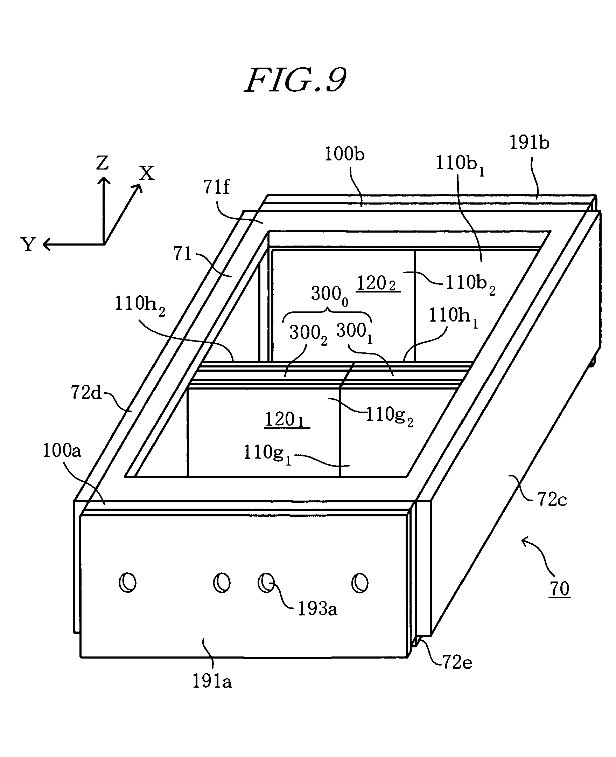

FIG. 9 is a schematic perspective view showing a box-shaped sputtering unit 70 of a facing-targets sputtering apparatus according to a third embodiment of the present invention, the sputtering unit 70 being viewed from the side of a substrate (vacuum chamber). As shown in FIG. 9, a face 71f of a rectangular parallelepiped frame 71 serves as an opening of predetermined size which faces the substrate, and target units 100a and 100b having the same configuration as those of the first embodiment shown in FIG. 1 are mounted on the two facing faces which sandwich the opening face. The remaining three faces of the frame 71 are covered with closure plates 72c to 72e. As described above, two targets 110a₁ and 110a₂ (both are not illustrated) constituting a combined target are mounted on the target unit 100a, and two targets 110b₁ and 110b₂ constituting a combined target are mounted on the target unit 100b. Pole plates 191a and 191b are respectively mounted on the back surfaces of the target units 100a and 100b.

On the closure plate 72e mounted on the face (on the bottom side) which faces the opening face, a combined intermediate target unit 300₀ is mounted as follows. The combined intermediate target unit 300₀ includes two intermediate target units 300₁ and 300₂, in which the corresponding targets are aligned in parallel. The intermediate target units 300₁ and 300₂ have the same configuration as the intermediate target unit 300 of the aforementioned second embodiment, except that the arrangement of the magnet holding casings serving as magnet holding means is partially varied. Specifically, targets 110h₁ and 110g₁ and targets 110h₂ and 110g₂ are mounted on the target mounting surfaces on the respective sides of the intermediate unit supports 301₁ and 301₂ of the intermediate target units 300₁ and 300₂. As shown in FIG. 9, the combined intermediate target unit 300₀ is provided between the target units 100a and 100b, each including a combined target, such that the target unit 300₀ is in parallel with the target units 100a and 100b. Therefore, two pairs of combined targets, each including two targets aligned in a Y direction (specifically, in a lateral direction), are provided; two facing-targets sputtering units, each including a pair of combined targets, are provided on the respective sides of the combined intermediate target unit 300₀; and these facing-targets sputtering units are combined by the combined intermediate target unit 300₀, whereby a combined facing-targets sputtering unit is configured.

The target units 100a and 100b have the same configuration as those of the first embodiment described above with reference to FIGs. 1 to 3, and thus detailed description of the target units is omitted. The intermediate target unit of the present embodiment will next be described in detail.

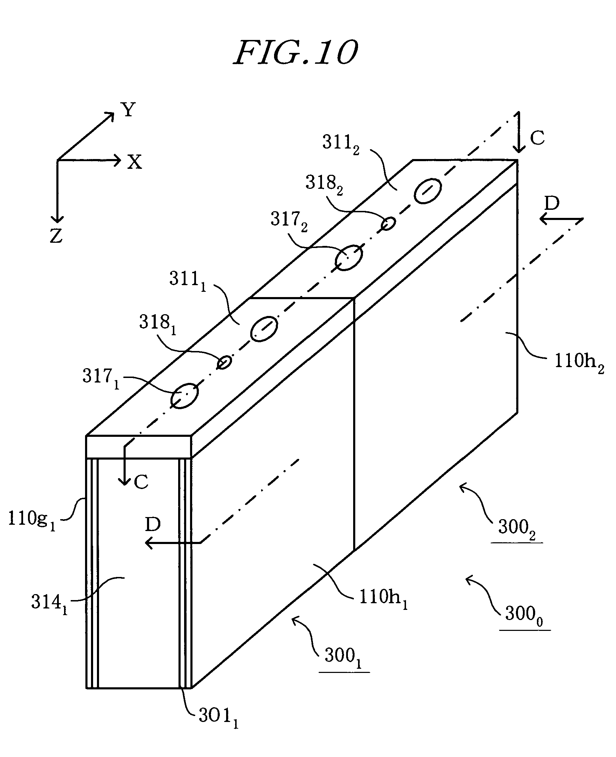

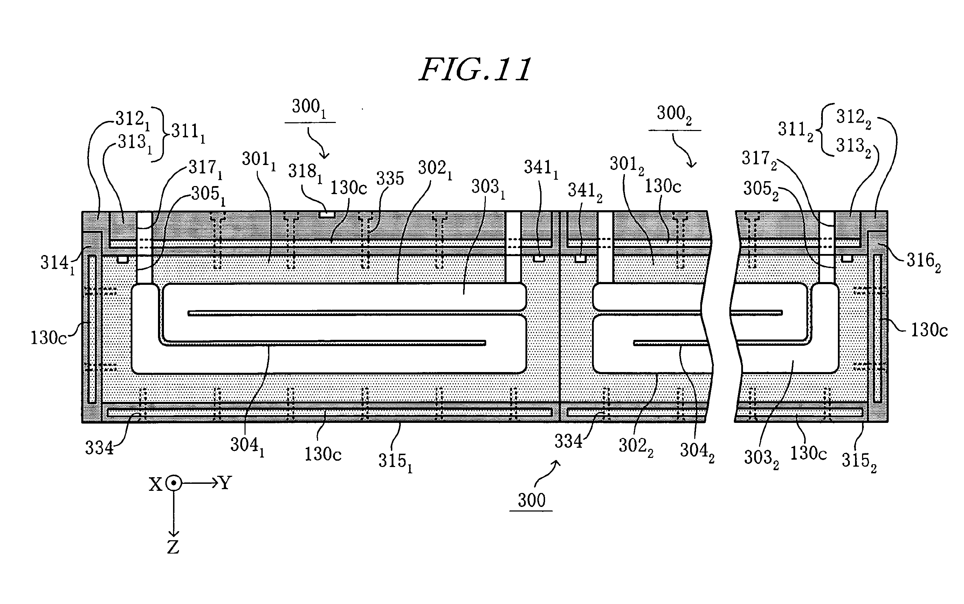

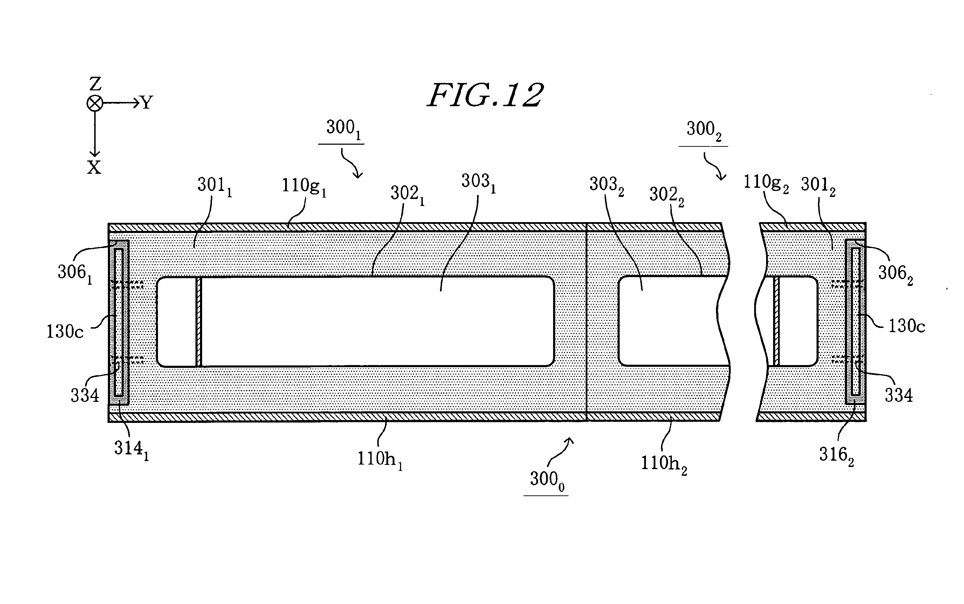

FIG. 10 is a perspective view of the combined intermediate target unit 300₀ including the two intermediate target units 300₁ and 300₂. FIG. 11 is a cross-sectional view of the target unit shown in FIG. 10, as taken along line C-C; and FIG. 12 is a cross-sectional view of the target unit shown in FIG. 10, as taken along line D-D. As shown in FIGS. 11 and 12, intermediate unit supports 301₁ and 301₂ have, in their interiors, zigzag cooling trenches 303₁ and 303₂ comparted by partition walls 304₁ and 304₂, whereby cooling jackets 302₁ and 302₂ are formed. Connection ports 305₁ are formed on both ends of the cooling trench 303₁, and connection ports 305₂ are formed on both ends of the cooling trench 303₂. Cooling water is supplied or drained through tubes connected to the connection ports. As shown in FIGS. 10 to 12, the targets 110g₁ and 110h₁ and the targets 110g₂ and 110h₂ are respectively bonded to the target mounting surfaces on both sides of the intermediate unit supports 301₁ and 301₂ by means of, for example, indium. In three surfaces (other than the surface at which the intermediate unit supports 301₁ and 301₂ are in contact (i.e., bonded) with each other), magnet accommodation trenches 306₁ and 306₂ are provided. In the magnet accommodation trenches 306₁ and 306₂ provided in the two surfaces of the above three surfaces (excluding the surface on the open-air side (on the top side as viewed in FIG. 10)), respectively, magnet holding casings 314₁ and 315₁ and magnet holding casings 315₂ and 316₂ for accommodating the permanent magnets 130c in a direction perpendicular to the targets are mounted by means of screws 334.

On the open-air-side surfaces of the intermediate unit supports 301₁ and 301₂ are mounted magnet holding tools 311₁ and 311₂ which serve as magnet holding means for accommodating the permanent magnets 130c and serve as sections for connecting the unit supports to the closure plate 72e provided outside the target units. The magnet holding tools 311₁ and 311₂ are formed of main bodies 312₁ and 312₂ (each having a step-down concave section for holding the permanent magnet 130c so as to allow the magnet 130c to generate a magnetic field in a direction perpendicular to the targets) and lids 313₁ and 313₂ which are mated in the step-down concave sections (for drawing simplification, the step-down concave sections are illustrated as concave sections having no steps in FIG. 11). The main bodies 312₁ and 312₂ and the lids 313₁ and 313₂ of the magnet holding tools 311₁ and 311₂ are hermetically mounted on the intermediate unit supports 301₁ and 301₂ by means of bolts 335, with the permanent magnets 130c being held in the holding tools. The magnet holding tools 311₁ and 311₂ have through holes 317₁ and 317₂ for connecting cooling water supply/drainage tubes, and the lids 313₁ and 313₂ have, on their top surfaces, wire connection sections 318₁ and 318₂ for connecting sputtering power supply wires. The cooling jackets 302₁ and 302₂ of the intermediate unit supports are shielded from the vacuum space by means of O rings 341₁ and 341₂ provided on the back surfaces of the main bodies 312₁ and 312₂ of the magnet holding tools 311₁ and 311₂ and by means of O rings (not illustrated, corresponding to the O ring 342 shown in FIG. 8) provided on the surfaces on the open-air side (on the top side as viewed in FIG. 11) of the main bodies 312₁ and 312₂. Similar to the case of the second embodiment, the magnet holding tools 311₁ and 311₂ are mounted, via insulating plates, on the closure plate 72e by means of non-illustrated bolts having electrically insulating sleeves. Thus, the combined intermediate target unit 300₀ in which the intermediate target units 300₁ and 300₂ are aligned in a Y direction is supported by the closure plate 72e in an electrically insulated manner, whereby the box-shaped sputtering unit 70 shown in FIG. 9 is assembled. Similar to the case of the second embodiment, auxiliary electrodes (not illustrated) for absorbing excess electrons generated in the confinement spaces are provided on the closure plate 72e, such that the auxiliary electrodes are located in the vicinity of the front end portions of the combined targets.

In the thus-assembled box-shaped sputtering unit 70, as shown in FIG. 9, there are formed a facing-targets sputtering unit including the confinement space 120₁ provided between the facing targets 110a₁ and 110a₂ (both are not illustrated) and targets 110g₁ and 110g₂, and a facing-targets sputtering unit including the confinement space 120₂ provided between the facing targets 110b₁ and 110b₂ and targets 110h₁ and 110h₂. In the facing-targets sputtering unit including the confinement space 120₁, a facing-mode magnetic field extending in an X direction in such a manner as to surround the confinement space 120₁ is generated from the peripheral edges of the combined targets formed of the Y-direction-aligned targets (110a₁ + 110a₂ and 110g₁ + 110g₂) . In the facing-targets sputtering unit including the confinement space 120₂, a facing-mode magnetic field extending in an X direction in such a manner as to surround the confinement space 120₂ is generated from the peripheral edges of the combined targets formed of the Y-direction-aligned targets (110b₁ + 110b₂ and 110h₁ + 110h₂) . Meanwhile, in each of the combined targets, a magnetron-mode magnetic field is generated along the peripheral edges of the combined target; i.e., along the peripheral edges of the sides of a target (excluding the side which is in contact with the corresponding side of the adjacent target).

Like the situations of the first and second embodiments, the box-shaped sputtering unit 70 is hermetically mounted on the chamber wall of the vacuum chamber by means of bolts such that the opening of the unit 70 (i.e., the opening face of the frame 71 on the top side as viewed in FIG. 9) faces the vacuum chamber. Therefore, the vacuum chamber is electrically connected to the frame 71 by means of attachment bolts. Similar to the case of the aforementioned embodiments, a substrate is placed in the vacuum chamber so as to face the aforementioned opening, and a film is formed on the substrate. As described above in the second embodiment, during the course of film formation, sputtered particles generated in the confinement spaces 120₁ and 120₂ of the facing-targets sputtering units approach a region directly below the combined intermediate target unit 300₀, as well as regions directly below the confinement spaces 120₁ and 120₂. Therefore, the thickness of a film to be formed on the region directly below the target unit 300₀ can be adjusted to be equal to that of a film to be formed on the regions directly below the confinement spaces 120₁ and 120₂; i.e., a film having almost uniform thickness can be formed on a substrate of large area.

In the third embodiment, two facing-targets sputtering units are formed by providing one combined intermediate target unit 300₀, and two targets are aligned in a Y direction in each of the combined targets. However, two or more combined intermediate target units 300₀ may be provided between the target units 100a and 100b, and/or three or more targets may be aligned in a Y direction, to thereby form a film on a substrate having a larger area. The number of intermediate target units to be provided or targets to be aligned can be arbitrarily selected. Therefore, the resultant facing-targets sputtering apparatus can treat a substrate of large area whose lateral and longitudinal dimensions are not limited essentially.

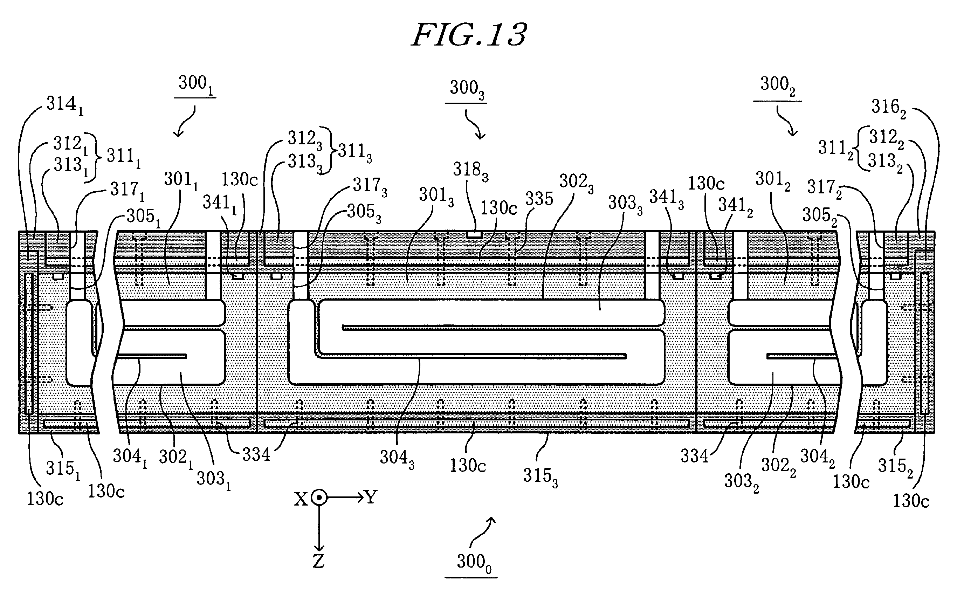

FIG. 13 is a cross-sectional view showing the configuration of a combined intermediate target unit 300₀ in which three targets are aligned in a Y-direction. In this case, the combined intermediate target unit 300₀ includes terminal intermediate target units 300₁ and 300₂, and a central intermediate target unit 300₃ provided between the target units 300₁ and 300₂. The terminal intermediate target units 300₁ and 300₂ have the same configuration as the units 300₁ and 300₂ shown in FIG. 11, and thus detailed description thereof is omitted. Similar to the case of the intermediate unit supports of the terminal intermediate target units, an intermediate unit support 301₃ of the central intermediate target unit 300₃ has, in its interior, a cooling trench 303₃ comparted by a partition wall 304₃, whereby a cooling jacket 302₃ is formed. Connection ports 305₃ are formed on both ends of the cooling trench 303₃, and cooling water is supplied or drained through tubes connected to the connection ports.

In the surfaces of the central intermediate unit support 301₃ that are parallel to an X-Z plane (specifically, in the surfaces which are jointed with the terminal intermediate unit supports 301₁ and 301₂), no permanent magnet is provided. In the surfaces of the intermediate unit support 301₃ that are parallel to an X-Y plane (specifically, in the surface serving as a section to be connected to the outside and the surface opposite to the connection surface), magnet accommodation trenches (not illustrated) for accommodating magnets are formed. Similar to the case of the terminal intermediate target units 300₁ and 300₂, on the surface on the open-air side (on the top side as viewed in FIG. 13) of the intermediate unit support 301₃ is mounted a magnet holding tool 311₃ which serves as magnet holding means for accommodating the permanent magnet 130c and serves as a section for connecting the unit support to the closure plate provided outside the target units. The magnet holding tools 311₃ is formed of a main body 312₃ having a step-down concave section, and a lid 313₃ which is mated in the step-down concave section (in FIG. 13, the step-down concave section is illustrated as a concave section having no steps). The main body 312₃ and the lid 313₃ of the magnet holding tool 311₃ are mounted on the intermediate unit support 301₃ by means of bolts 335. The magnet holding tool 311₃ has through holes 317₃ for connecting cooling water supply tubes, and the lid 313₃ has, on its top surface, a wire connection section 318₃ for connecting a sputtering power supply wire. The cooling jacket 302₃ of the intermediate unit support 301₃ is shielded from the vacuum space by means of an O ring 341₃ provided on the back surface of the main body 312₃ of the magnet holding tool 311₃ and by means of an O ring (not illustrated, corresponding to the O ring 342 shown in FIG. 8) provided on the surface on the open-air side (on the top side as viewed in FIG. 13) of the main body 312₃. Similar to the case of the magnet holding tools 311₁ and 311₂, the magnet holding tool 311₃ is mounted, via an insulating plate, on the closure plate by means of bolts.

Each of the support modules of the target units 100a and 100b, which are provided so as to face the combined intermediate target unit 300₀, includes three target modules. In this case, the terminal target modules are constructed in a manner similar to that of the target modules 200a₁ and 200a₂ shown in FIGs. 2 and 3, and the central target module is configured such that two surfaces parallel to a Z-X plane are jointed with the terminal target modules, and two surfaces parallel to an X-Y plane are in contact with the peripheral wall of the support main body. Although not illustrated, similar to the case of the second embodiment, all the exposed surfaces (other than the target surfaces) of the combined intermediate target unit are covered with shield plates.

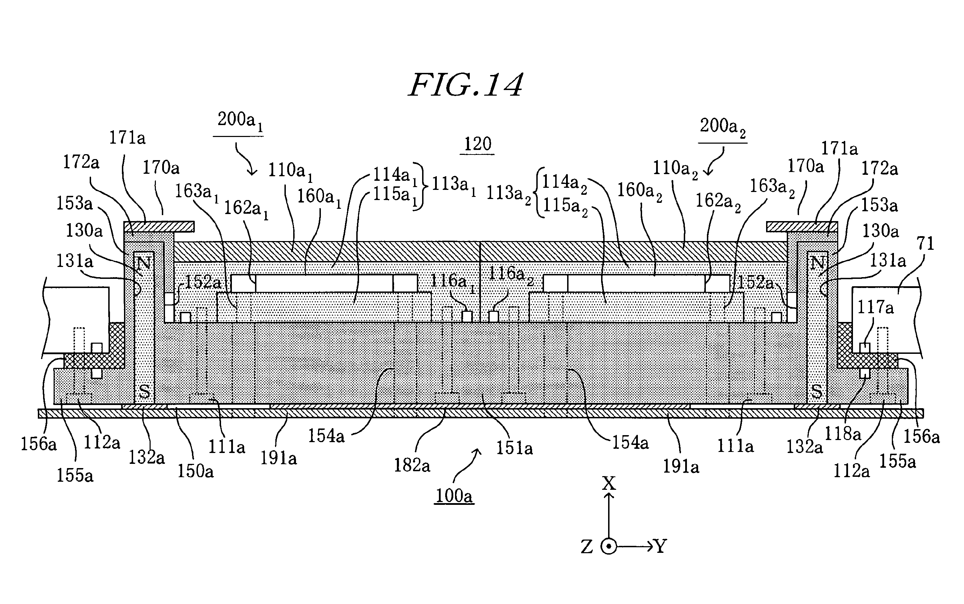

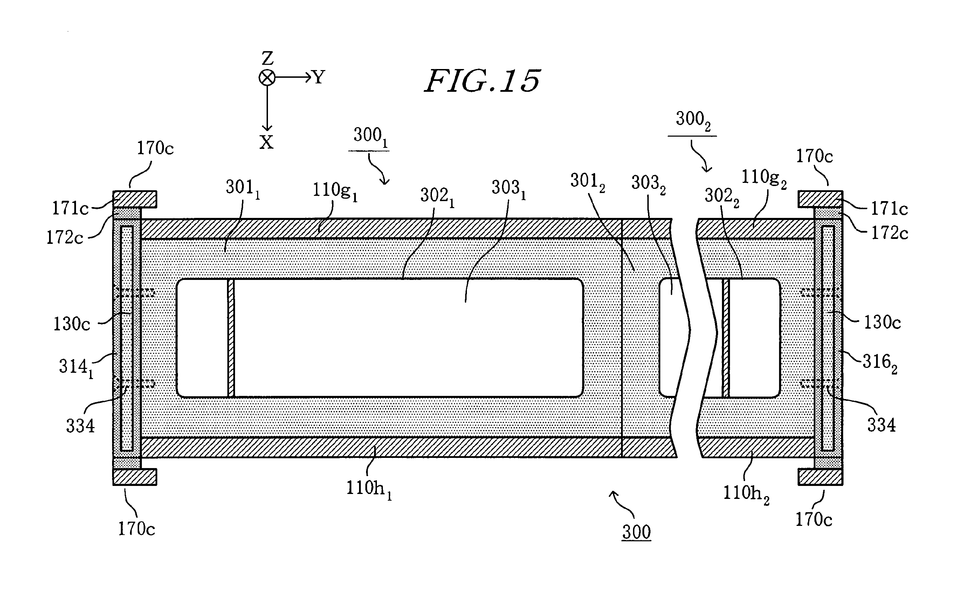

In each of the facing-targets sputtering apparatuses of the first through third embodiments, the targets are formed of a non-magnetic material. In the case where the targets are formed of a magnetic material, preferably, the targets are provided so as not to cover the magnetic poles of permanent magnets for generating a facing-mode magnetic field. More preferably, electron reflection means is provided on the peripheral edges of the targets (when the targets are aligned in a Y direction, electron reflection means is provided on the peripheral edges of a combined target formed of the thus-aligned targets). FIG. 14 is a cross-sectional view showing a target unit 100a in which two targets formed of a magnetic material are aligned in a Y direction; and FIG. 15 is a cross-sectional view showing an intermediate target unit in which two targets formed of a magnetic material are aligned in a Y direction.

In FIG. 14, components corresponding to those of the first embodiment shown in FIG. 3 are denoted by common reference numerals, and repeated description is omitted. In the case of the first embodiment, overhanging portions which cover the peripheral wall 153a of the support main body 151a are formed on the backing sections 113a₁ and 113a₂ of the target modules 200a₁ and 200a₂. However, in the case shown in FIG. 14, such overhanging portions are omitted, and backing sections 113a₁ and 113a₂ are formed to assume a rectangular parallelepiped shape. As shown in FIG. 14, electron reflection means 170a is mounted on a peripheral wall 153a of a support main body 151a. The electron reflection means 170a is constructed such that electron reflection plates 171a having a width so as to face the peripheral edges of targets 110a₁ and 110a₂ are supported by mounting sections 172a which have an "L"-shaped cross section and are formed of copper (i.e., highly thermally conductive material). The electron reflection plates 171a are formed of a ferromagnetic material (e.g., an iron plate) such that the plates 171a can also serve as the magnetic poles of magnetic-field generation means.

In FIG. 15, components corresponding to those of the third embodiment shown in FIG. 12 are denoted by common reference numerals, and repeated description is omitted. In the case of the third embodiment, the magnet accommodation trenches 306₁ and 306₂ are provided in three surfaces of the intermediate unit supports 301₁ and 301₂. However, in the case shown in FIG. 15, magnet accommodation trenches are not formed in intermediate unit supports 301₁ and 301₂, and the intermediate unit supports 301₁ and 301₂ have a rectangular parallelepiped shape. As shown in FIG. 15, electron reflection means 170c is mounted on both end surfaces of each of magnet holding casings 314₁ and 316₂ for accommodating the permanent magnets 130c. The electron reflection means 170c is constructed such that electron reflection plates 171c having a width so as to face the peripheral edges of targets are supported by mounting sections 172c which are formed of copper plates (i.e., highly thermally conductive material). The electron reflection plates 171c are formed of a ferromagnetic material (e.g., an iron plate) such that the plates 171c can also serve as the magnetic poles of magnetic-field generation means.

Although not illustrated in FIG. 15, electron reflection means 170c are mounted on both end surfaces of each of the magnet holding tools 311₁ and 311₂, and on both end surfaces of each of the magnet holding casings 315₁ and 315₂ (see FIG. 11). With this configuration, the peripheral edges of a combined target formed of the targets 110g₁ and 110g₂ and a combined target formed of the targets 110h₁ and 110h₂ (i.e., 110g₁ + 110g₂ and 110h₁ + 110h₂) are covered with the electron reflection means 170c.

Next will be described film formation examples in which films were actually formed by means of the facing-targets sputtering apparatuses of the first and second embodiments.

### [Film formation example 1]

In the facing-targets sputtering apparatus of the first embodiment shown in FIG. 1, which includes facing combined targets, five target modules were aligned in a Y direction (i.e., a lateral direction) so that the total lateral length of each of the combined targets was 1300 mm, and the distance between the facing combined targets was regulated to 90 mm. A substrate holder was placed at a position 80 mm away from the bottom ends of the targets, and glass substrates are laterally aligned on the substrate holder. Electric power was supplied from a common power supply to both the combined targets formed of a metal oxide in parallel, thereby forming, on the glass substrates, a metal oxide film so as to attain a maximum thickness of 1 µm or more. The thickness of the thus-formed film was measured by means of a stylus profilometer for evaluation of film thickness distribution.

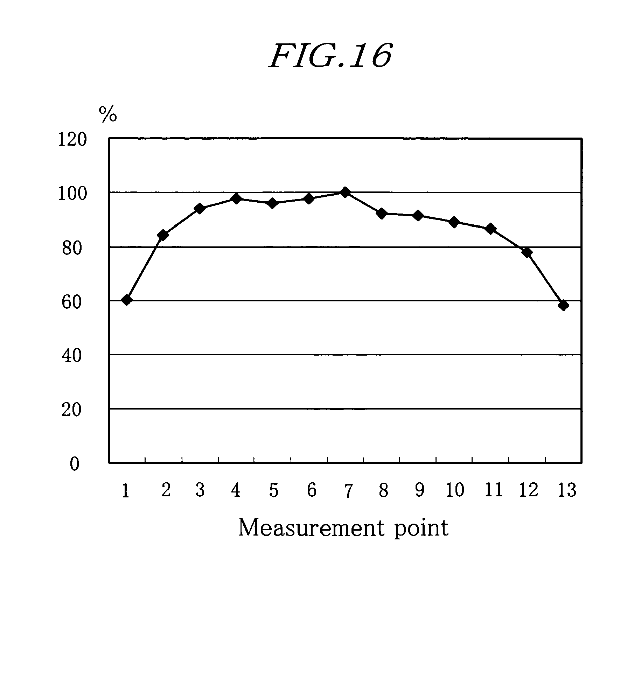

FIG. 16 shows the results of evaluation of film thickness distribution. FIG. 16 shows the distribution of film thicknesses (in a Y direction) as measured at points corresponding to the centerline between the targets. The film thickness measured at the center point (measurement point 7 in FIG. 16) was taken as 100% (i.e., standard), and film thicknesses measured at other measurement points were represented by percentage (%) with respect to the standard value. The measurement points were located at intervals of 10 cm in a Y direction.

As is clear from the graph of FIG. 16, even when the film width is as large as 1 m, the film has a uniform thickness; i.e., film thicknesses fall within a range of ± 10% with respect to the average thickness. The data corresponds to the case where the film was not subjected to any film thickness regulation by means of, for example, a mask for film thickness regulation. This indicates that when any film thickness regulation is performed; for example, a mask is provided in the vicinity of a center portion between the targets, and the thickness of a portion of a film corresponding to the center portion is reduced, the resultant film meets a more strict requirement in terms of film thickness distribution (e.g., ± 5% with respect to the average thickness). Thus, when the facing-targets sputtering apparatus including combined targets is employed, a film can be continuously formed, by means of an in-line system, on a substrate of large width which is required for, for example, the production of a functional film (e.g., a transparent, electrically conductive film).

### [Film formation example 2]

In the facing-targets sputtering apparatus of the second embodiment shown in FIG. 6, which includes combined facing-targets sputtering units, targets having a Z-direction dimension of 100 mm and a Y-direction dimension of 315 mm were employed such that film formation can be performed on an 8-inch wafer. In the combined facing-targets sputtering units, the thickness of the intermediate target unit (i.e., the distance between the surfaces of the targets provided on opposite surfaces of the target unit) was regulated to 60 mm; the distance between the facing targets was regulated to 145 mm; and the X-direction dimension and Y-direction dimension of the opening face were regulated to 350 mm and 315 mm, respectively. In the target units provided at both terminals of the sputtering unit, the permanent magnets 180a and 180b employed in the second embodiment for magnetic-field regulation were omitted.

In the facing-targets sputtering apparatus, an 8-inch wafer was placed at a position 100 mm away from the targets formed of a metal oxide, and electric power was supplied from a common power supply to the terminal target units and the intermediate target unit in parallel, thereby forming, on the wafer, a metal oxide film so as to attain a maximum thickness of 1,000 Å or more. The thickness of the thus-formed film was measured by means of a stylus profilometer for evaluation of film thickness distribution.

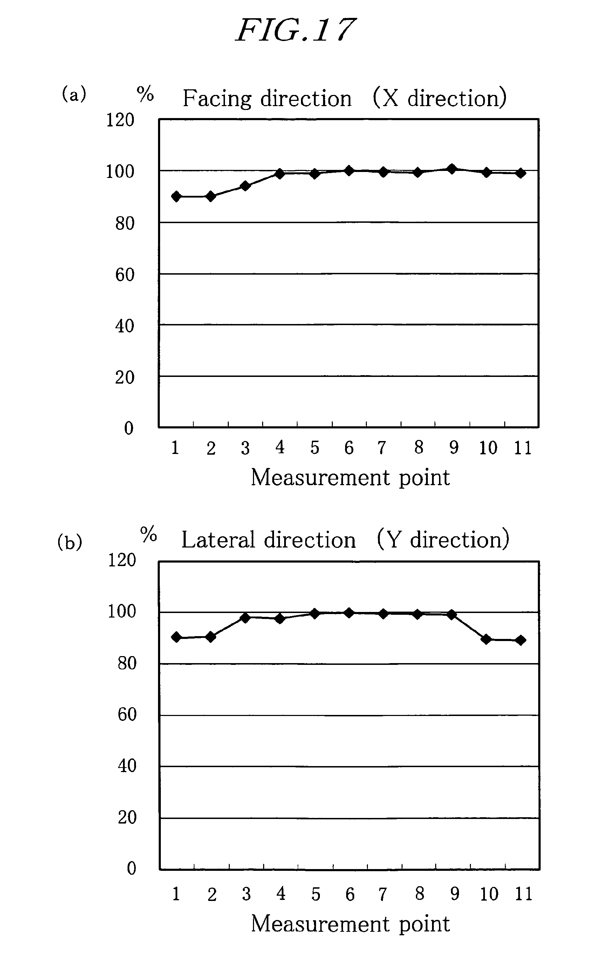

FIGs. 17(a) and 17(b) show the results of evaluation of film thickness distribution. FIG. 17(a) shows the film thickness distribution in an X direction (i.e., facing direction). Film thicknesses were measured on the X-direction centerline of the opening face at intervals of 10 mm. FIG. 17(b) shows the film thickness distribution in a Y direction (i.e., lateral direction). Film thicknesses were measured on the Y-direction centerline of the opening face at intervals of 10 mm. Measurement point 6 corresponds to the center of the opening face. The film thickness measured at the center of the opening face was taken as 100% (i.e., standard), and film thicknesses measured at other measurement points were represented by percentage (%) with respect to the standard value.

As is clear from the graphs of FIG. 17, even when an 8-inch wafer is employed, film thicknesses measured in an X or Y direction fall within a range of ± 10% with respect to the average thickness. The results imply that when a 6-inch wafer is employed, the resultant film has very uniform thickness; i.e., film thicknesses fall within a range of ± 5% with respect to the average thickness. In addition, when, for example, a mask for film thickness regulation is provided, uniformity in film thickness can be further improved. Thus, when the facing-targets sputtering apparatus including combined facing-targets sputtering units is employed, extension of a film formation region in a facing direction, which has conventionally been impossible, can be attained, and a film can be formed on a substrate of large area required for the production of semiconductor devices while the substrate is held stationary.

## Claims

1. A facing-targets type sputtering apparatus for forming a film on a substrate, comprising:
a) a facing target unit comprising:
i) a target module including a backing section with cooling means and a rectangular target mounted on the front surface of the backing section;
ii) a unit support including a module mounting section on a front surface in which the target module is mounted and a magnet accommodation section at the periphery of the module mounting section for accommodating permanent magnets such that the permanent magnets generate a facing-direction magnetic field and;
iii) permanent magnets being accommodated in the magnet accommodation sections;
and
b) a facing-targets sputtering assembly including a pair of the facing target units which are disposed such that the targets face each other across a confinement space with a predetermined distance, wherein a film is formed on a substrate which is disposed laterally to the confinement space so as to face the side face of the confinement space,
**characterized in that**;
the module mounting section of the unit support is divided into a plurality of mounting compartments with a predetermined length in the lateral direction, and each of the target module having a predetermined length corresponding to the length of the mounting compartment is hermetically provided on each of the mounting compartments independently and the target modules are mounted on all the mounting compartments, whereby a combined target module formed of a plurality of the target modules aligning in the lateral direction covers entirely a film formation region of the substrate extending in the lateral direction.

2. A facing-targets type sputtering apparatus according to claim 1, wherein the facing-targets sputtering assembly is a box-shaped facing-targets sputtering assembly which includes a rectangular parallelepiped frame and in which the facing target units are respectively mounted on two opposing faces of the frame which are located adjacent to an opening face which faces the substrate, and the remaining three faces of the frame are closed hermetically.

3. A facing-targets type sputtering apparatus according to claim 1, wherein the target of the facing target unit is provided so as to cover the front end face of the magnet accommodation section in the opposing direction.

4. A facing-targets type sputtering apparatus according to claim 3, wherein the front end faces of the magnet accommodation sections are covered with projections formed at the front end portions of the backing sections, and the targets are provided so as to cover the projections.

5. A facing-targets type sputtering apparatus according to claim 1, wherein electron reflection means for reflecting electrons are provided on the front end faces of the magnet accommodation sections.

6. A facing-targets type sputtering apparatus according to claim 1, wherein an auxiliary electrode for absorbing electrons is provided in the confinement space formed between the facing targets.

7. A facing-targets type sputtering apparatus according to claim 6, wherein the auxiliary electrode for absorbing electrons is provided in the vicinity of the front end faces of the magnet accommodation sections so as to extend along the front end faces.

8. A facing-targets type sputtering apparatus according to claim 1, wherein the permanent magnets of the facing target units are provided so as to generate a facing-mode magnetic field extending in the facing direction, and an arcuate magnetron-mode magnetic field extending in the vicinity of peripheral edges of the surfaces of the targets.

9. A facing-targets type sputtering apparatus according to claim 1, wherein the unit support includes magnetic-field regulation means for mainly regulating a magnetron-mode magnetic field.

10. A facing-targets type sputtering apparatus for forming a film on a substrate, comprising:
a facing-targets sputtering assembly including a pair of facing target units which are disposed such that a pair of targets face each other across a confinement space with a predetermined distance and permanent magnets which are disposed at the periphery of each of the targets so as to generate a magnetic field in a facing-direction, wherein a film is formed on a substrate which is disposed laterally to the confinement space so as to face the side face of the
confinement space;
**characterized in that**;
a combined facing-targets sputtering assembly is formed by combining a plurality of the facing-targets sputtering assemblies by means of an intermediate target unit which includes a plate-like intermediate unit support having, on each of its facing-direction surfaces, one of targets of the facing-targets sputtering assemblies to be combined and permanent magnets provided along the periphery of the intermediate unit support so as to generate a facing-direction magnetic field; and
the total thickness of the intermediate target unit including the thickness of the targets provided on its both surfaces is equal to or less than a specified thickness value under that the sum of the thickness of respective films on a substrate's portion facing to the side face of the intermediate unit support is above a predetermined thickness, the respective film formed by each of the facing-targets sputtering assemblies provided at the both side of the intermediate target unit, whereby a plurality of film formation regions corresponding to each of the facing-targets sputtering assemblies to be combined are combined in the facing-direction to be a single combined film formation region and thereby the combined facing-targets sputtering assembly with a single film formation region is provided.

11. A facing-targets type sputtering apparatus according to claim 10, wherein each of the target units provided on both terminals of the combined facing-targets sputtering assembly is a terminal target unit comprising:
a) a target module including a backing section with cooling means and a rectangular target mounted on the front surface of the backing section;
b) a unit support including a module mounting section on a front surface which the target module is mounted and a magnet accommodation section at the periphery of the module mounting section for accommodating permanent magnets such that the permanent magnets generate a facing-direction magnetic field and;
c) permanent magnets being accommodated in the magnet accommodation section;
and the intermediate target unit is an intermediate target unit comprising:
a) an intermediate target module including an intermediate unit support having cooling means and targets mounted on both surfaces of the intermediate unit support; and
b) permanent magnets being provided along the peripheral edges of the targets so as to generate a facing-direction magnetic field.

12. A facing-targets type sputtering apparatus according to claim 11, wherein the combined facing-targets sputtering assembly is a box-shaped facing-targets sputtering assembly including a rectangular parallelepiped frame, in which the terminal target units are respectively mounted on two opposing faces of the frame which are located adjacent to an opening face which faces the substrate, and the remaining three faces of the frame are closed hermetically; and the intermediate target unit is supported on a closure plate for closing the face of the frame that is opposed to the opening face.

13. A facing-targets type sputtering apparatus according to claim12,
wherein the terminal target unit is a combined target unit in which the module mounting section of the unit support is divided into a plurality of mounting compartments with a predetermined length in the lateral direction which is parallel to the target surface and the substrate surface, and one target module with a predetermined length corresponding to the length of the mounting compartment is hermetically provided on each of the mounting compartments independently, whereby a combined target module formed of a plurality of the target modules aligning in the lateral direction covers entirely a film formation region of the substrate extending in the lateral direction:
and the intermediate target unit is a combined intermediate target unit comprising;
a plurality of intermediate target modules with a predetermined length including an intermediate unit support having cooling means and targets mounted on both surfaces of the intermediate unit support, wherein the intermediate target modules are aligned in a lateral direction and jointed with one another so that the total lateral length of the thus-aligned intermediate target modules is equal to the total lateral length of the terminal target unit; and
the permanent magnets being provided along the peripheral edges of the thus-aligned intermediate target modules so as to generate a facing-direction magnetic field;
and thereby a combined intermediate target module formed of a plurality of the intermediate target modules being aligned in the lateral direction covers entirely a film formation region of the substrate extending in the lateral direction.

14. A facing-targets type sputtering apparatus according to claim 13, wherein, each of the intermediate target modules provided on both terminals in a lateral direction of the combined intermediate target unit has the magnet holding means along its three side face exclusive of a side face contact with a neighboring intermediate target module and when a middle intermediate target module is provided between the terminal intermediate target modules, the middle intermediate target module has the magnet holding means on the atmosphere-side side face and its opposite side face except of side faces contact with a neighboring intermediate target module, and the permanent magnets are accommodated in the magnet holding means.

15. A facing-targets type sputtering apparatus according to claim 10, wherein, the intermediate target unit has the magnet holding means on four side face of the intermediate unit support exclusive of the target mounting surfaces, and the permanent magnets are accommodated in the magnet holding means.

16. A facing-targets type sputtering apparatus according to claim 14, wherein the magnet holding means provided on the atmosphere-side comprises (a) a main body having a concave section for holding the permanent magnets in a predetermined direction, the back face of the concave section and the front end face of a side portion of the concave section being made a sealing surface and (b) a lid which covers the concave section of the main body, and thereby the magnet holding means is constituted as a connection section for connecting the intermediate target module to the atmospheric outside , where the back face of the concave section is hermetically mounted to the atmosphere-side side face of the intermediate unit support and the front surface of the lid is hermetically mounted to the closure plate by sealing on the front end face of a side portion of the concave section, and connection to the cooling means of the intermediate unit support and connection of a power supply to the targets can be attained through the connection section.

17. A facing-targets type sputtering apparatus according to claim 10, wherein the predetermined thickness is equal to or greater than the average thickness of a film formed on the film formation regions where the substrate is disposed.

18. A facing-targets type sputtering apparatus according to claim 14, wherein the targets are provided so as to cover the front end faces of the magnet accommodation sections and both the side faces of the magnet holding means in the facing direction.

19. A facing-targets type sputtering apparatus according to claim 18, wherein the front end faces of the magnet accommodation sections and both the side faces of the magnet holding means in the facing direction are covered with projections formed at front end portions of the backing sections and the intermediate unit support, and the targets are provided so as to cover the projections.

20. A facing-targets type sputtering apparatus according to claim 14, wherein electron reflection means for reflecting electrons are provided on the front end faces of the magnet accommodation sections and on both the side faces of the magnet holding means in the facing direction.

21. A facing-targets type sputtering apparatus according to claim 10, wherein auxiliary electrodes for absorbing electrons are provided in the confinement spaces formed between the facing targets.

22. A facing-targets type sputtering apparatus according to claim 21, wherein the auxiliary electrodes are provided in the vicinity of the front end faces of the magnet accommodation sections and both the side faces of the magnet holding means in the facing direction, such that the auxiliary electrodes extend along the front end faces and both the side faces.

23. A facing-targets type sputtering apparatus according to claim 10, wherein the permanent magnets are provided so as to generate a facing-mode magnetic field extending in the facing direction, and an arcuate magnetron-mode magnetic field extending in the vicinity of peripheral edges of the surfaces of the targets.

24. A facing-targets type sputtering apparatus according to claim 11, wherein the unit support includes magnetic-field regulation means for mainly regulating a magnetron-mode magnetic field.

## Amended claims

### Amended claims under Art. 19.1 PCT

**1.** (Amended) A facing-targets type sputtering apparatus for forming a film on a substrate, comprising:
a) a facing target unit comprising:
i) a target module including a backing section with cooling means and a rectangular target mounted on the front surface of the backing section;
ii) a unit support including a module mounting section on a front surface in which the target module is mounted and a magnet accommodation section at the periphery of the module mounting section for accommodating permanent magnets such that the permanent magnets generate a facing-direction magnetic field and;
iii) permanent magnets being accommodated in the magnet accommodation sections;
and
b) a facing-targets sputtering assembly including a pair of the facing target units which are disposed such that the targets face each other across a confinement space with a predetermined distance, wherein a film is formed on a substrate which is disposed laterally to the confinement space so as to face the side face of the confinement space,
**characterized in that**;
the module mounting section of the unit support is divided into a plurality of mounting compartments with a predetermined length in a lateral direction which is parallel to the target surface and the substrate surface, and each of the target module having a predetermined length corresponding to the length of the mounting compartment is hermetically provided on each of the mounting compartments independently and the target modules are mounted on all the mounting compartments, whereby a continuously combined elongated target formed of a plurality of the target modules aligning continuously in the lateral direction covers entirely a film formation region of the substrate extending in the lateral direction.
